# EUROPÄISCHE PATENTSCHRIFT

(11) **EP 2 438 620 B1**
(45) Veröffentlichungstag und Bekanntmachung des Hinweises auf die Patenterteilung: **08.01.2014**
(21) Anmeldenummer: 10737743.4
(22) Anmeldetag: 01.06.2010
(51) Int. Cl.: H01L 31/0224

(54) **SOLARZELLE MIT BENACHBARTEN ELEKTRISCH ISOLIERENDEN PASSIVIERBEREICHEN MIT HOHER OBERFLÄCHENLADUNG GEGENSÄTZLICHER POLARITÄT UND HERSTELLUNGSVERFAHREN**
SOLAR CELL COMPRISING NEIGHBORING ELECTRICALLY INSULATING PASSIVATION REGIONS HAVING HIGH SURFACE CHARGES OF OPPOSING POLARITIES AND PRODUCTION METHOD
CELLULE SOLAIRE À ZONES DE PASSIVATION ADJACENTES ÉLECTRIQUEMENT ISOLANTES, PRÉSENTANT UNE CHARGE SUPERFICIELLE ÉLEVÉE DE POLARITÉ CONTRAIRE ET PROCÉDÉ DE FABRICATION ASSOCIÉ

(30) Priorität: 02.06.2009 DE 102009024807
(43) Veröffentlichungstag der Anmeldung: 11.04.2012
(73) Patentinhaber: Helmholtz-Zentrum Berlin für Materialien und Energie GmbH, 14109 Berlin (DE)
(72) Erfinder: STANGL, Rolf, 12435 Berlin (DE); RECH, Bernd, 12587 Berlin (DE)
(86) Internationale Anmeldenummer: PCT/DE2010/000625
(87) Internationale Veröffentlichungsnummer: WO 2010/139312

(56) Entgegenhaltungen:
- US-A- 4 315 097
- US-A- 4 886 555
- US-A- 5 356 488
- US-A1- 2004 187 916
- JAN SCHMIDT ET AL.: "Atomic-layer-deposited aluminum oxide for the surface passivation of high-efficiency silicon solar cells", PROCEEDINGS PVSC, Bd. 33, 2008, Seiten 1-5, XP002628726, DOI: 10.1109/PVSC.2008.4922636 in der Anmeldung erwähnt

## Beschreibung

Die Erfindung bezieht sich auf eine Solarzelle mit
- einer photoaktiven, halbleitenden Absorberschicht, die der Erzeugung von Überschuss-Ladungsträger gegensätzlicher Polarität durch im Betriebsfall in die Vorderseite der Absorberschicht einfallendes Licht dient,
- der Ausbildung zumindest eines elektrischen Feldes in der Absorberschicht, das der Trennung der photogenerierten Überschuss- Ladungsträger gegensätzlicher Polarität, die zumindest eine minimale effektive Diffusionslänge L_{eff, min} in der Absorberschicht zurücklegen können, dient,
- ersten Kontaktelementen, die der Ableitung der Überschuss-Ladungsträger einer Polarität auf der im Betriebsfall lichtabgewandten Rückseite der Absorberschicht dienen,
- zweiten Kontaktelementen, die der Ableitung der Überschuss-Ladungsträger gegensätzlicher Polarität dienen, und
- zumindest einem auf die Rückseite der Absorberschicht aufgebrachten nicht dotierten, elektrisch isolierenden ersten Passivierbereich aus einem ersten nichthalbleitenden Material mit einer so hohen Oberflächenladung einer Polarität, dass eine Bandverbiegung der Absorberschicht in eine Richtung bis in oder nahe an die Entartung hervorgerufen wird, und
- zumindest einem nicht dotierten, elektrisch isolierenden zweiten Passivierbereich aus einem zweiten nichthalbleitenden Material mit einer so hohen Oberflächenladung gegensätzlicher Polarität, dass eine Bandverbiegung der Absorberschicht in die entgegengesetzte Richtung bis in oder nahe an die Entartung hervorgerufen wird,
- eine Anordnung auch der zweiten Kontaktelemente auf der Rückseite der Absorberschicht,
- zumindest eine erste Kontaktöffnung in jedem ersten elektrisch isolierenden Passivierbereich zum Anschluss eines ersten Kontaktelements
sowie auf ein Verfahren zur Herstellung solcher Solarzellen.

Photoaktive Bauelementstrukturen, die mit Hilfe von Halbleitern (z.B. Silizium) realisiert werden (z.B. Photodioden, Solarzellen) benutzen in der Regel entweder einen hochdotierten Halbleiter-Halbleiter-Übergang (z.B. pn oder pin Strukturen) oder einen Metall-Halbleiter-Übergang (Schottky-Kontakt) oder einen sehr dünnen Metall-Isolator(Tunneloxid)-Halbleiter-Übergang (MIS-Kontakt) zur selektiven Trennung der photogenerierten Überschuss-Ladungsträger. Hierbei wird das elektrische Feld, das sich aufgrund der genannten Übergänge in der photoaktiven, halbleitenden Absorberschicht ausbildet, zur selektiven Trennung von photogenerierten Überschuss-Ladungsträgern genutzt. Insbesondere wird das elektrische Feld hierbei immer primär über eine leitende Kontaktschicht (Emitterschicht bzw. Metallschicht bzw. Metall/Tunneloxid-Schicht), die sich zumindest in lokalisierten Bereichen auf dem Photoabsorber befindet, erzeugt (die Tunneloxid-Schicht im Falle eines MIS-Kontakts wird hierbei trotz des an sich isolierenden Charakters eines Oxids als effektiv leitende Kontaktschicht aufgefasst, da das Tunneloxid so dünn prozessiert werden muss, dass ein signifikanter Stromfluss in das Metall aufgrund von Tunnel-Transport-Prozessen möglich ist. Konkret erzeugen also alle genannten Übergänge (pn-Übergang, Schottky-Kontakt, MIS-Kontakt) ein elektrisches Feld bzw. eine Raumladungszone im Photoabsorber, welche dann zur Trennung der photogenerierten Ladungsträger eingesetzt wird.

Ist es die Zielvorgabe, eine möglichst effiziente Sammlung der photogenerierten Überschuss-Ladungsträger zu erreichen (z.B. die Entwicklung von Hocheffizienz-Solarzellen, z.B. basierend auf Silizium-Wafern), so stellen die hochdotierten Halbleiterschichten (insbesondere die Emitterschicht bei pn-Strukturen) sowie die Kontakt-Rekombination (am Metall-hochdotierter Halbleiter-Kontakt oder am Metall-Halbleiter-Kontakt oder am Metall-Tunneloxid-Halbleiter-Kontakt) aufgrund ihrer hohen Rekombinations-Aktivität einen den Wirkungsgrad der Solarzelle limitierenden Faktor dar. Ein verbreitetes Abhilfekonzept ist die Ausnutzung von Punktkontakten, um die unvermeidlichen Kontakt-Bereiche mit einer hohen Rekombinations-Aktivität zu minimieren. Dabei wird der Photoabsorber (z.B. der Silizium-Wafer) über eine elektrisch isolierende Passivierschicht (z.B. ein thermisch gewachsenes Oxid) ganzflächig passiviert und im Anschluss an einigen Bereichen lokal geöffnet (Punktkontakte oder Streifenkontakte). In diesen Bereichen findet dann die oben beschriebene Erzeugung einer Raumladungszone zur Trennung der photogenerierten Überschuss-Ladungsträger statt. Insbesondere muss dabei die elektrisch isolierende Passivierschicht eine niedrige Oberflächen-Rekombinations-Geschwindigkeit aufweisen (z.B. < 30 cm/s).

Passivierschichten reduzieren die Oberflächen-Rekombinations-Geschwindigkeit des Solarzellen-Absorbers. Sie können leitend (z.B. intrinsisches oder dotiertes hydrogenisiertes amorphes Silizium, a-Si:H) oder nichtleitend ausgebildet sein (z.B. Oxide, Nitride). Die meisten Passivierschichten funktionieren hauptsächlich durch eine Absättigung (Reduzierung) der Oberflächen-Defekte des Photoabsorbers (z.B. ein thermisch gewachsenes Oxid auf einem Siliziumwafer durch Absättigung der offenen "Dangling-Bonds"). Es ist jedoch auch möglich, eine geringe Oberflächen-Rekombinations-Geschwindigkeit über eine sehr hohe Oberflächenladung innerhalb der Passivierschicht zu erzielen. Die Oberflächenladung der Passivierschicht führt dann ebenfalls zu einer Ausbildung einer Raumladungszone im Photoabsorber. Ist die Oberflächenladung sehr hoch, so kann die resultierende Bandverbiegung des Absorbers bis in die Entartung oder nahe an die Entartung getrieben werden (vollständige Bandverbiegung, die Valenzband- bzw. die Leitungsband-Kante berührt dann an der Oberfläche des Halbleiters das Fermi-Energieniveau des Halbleiters). Die Dichte einer Ladungsträgersorte ist dann lokal an der Halbleiter-Oberfläche stark erhöht. Dort steht dann - je nach eingesetztem Material - jeweils nur eine Sorte photogenerierter Überschuss-Ladungsträger (entweder nur Überschuss-Elektronen oder nur Überschuss-Löcher, äquivalent "eine Polarität" und "entgegengesetzte Polarität") zur Verfügung, so dass trotz einer eventuell vorhandenen hohen Oberflächen-Defektdichte keine Oberflächen-Rekombination möglich ist. Bekannte Beispiele solcher Passivierschichten sind z.B. über plasmagestützte chemische Gasphasenabscheidung (PECVD) auf Silizium abgeschiedenes Siliziumnitrid (SiN (Akronym, nicht stöchiometrische Formel), sehr hohe positive Oberflächenladung) oder über "atomic layer deposition" (ALD) auf Silizium abgeschiedenes Aluminiumoxid (AIO (Akronym, nicht stöchiometrische Formel), sehr hohe negative Oberflächenladung).

### STAND DER TECHNIK

Aus der DE 196 02 313 A1 ist eine Solarzelle mit einem pn-Übergang und einer beidseitigen Kontaktierung bekannt. Zur Unterdrückung der Ladungsträger-Rekombination am lichtabgewandten, rückseitigen Kontakt ist die Solarzelle mit einer extern ansteuerbaren Feldelektrode ausgestattet. Diese liegt zwischen den Kontaktfingern auf einer Isolationsschicht auf der Absorberschicht und ist mit einer äußeren Spannungsquelle verbunden. Die auf einem negativen Potenzial liegende Feldelektrode erzeugt in der Grenzfläche Halbleiter-Isolator ein elektrisches Feld, das die in diesen Bereich eindiffundierenden Minoritätsladungsträger in Richtung des pn-Übergangs zurücktreibt, die Majoritätsladungsträger hingegen zum rückseitigen Kontakt beschleunigt. Zur Verringerung der Rekombinationsgeschwindigkeit auf der Vorderseite der Solarzelle, kann dort ebenfalls eine extern ansteuerbare Feldelektrode gegensätzlicher Polarisation vorgesehen sein, durch deren Feldeinwirkung die Majoritätsladungsträger zum hinteren Kontakt und die Minoritätsladungsträger zum vorderen Kontakt getrieben werden. Die Ladungsträgertrennung erfolgt aber ausschließlich am pn-Übergang.

Aus der WO 2007/022955 A1 ist eine rückseitenkontaktierte Solarzellen bekannt, bei der die elektrischen Felder zur Ladungsträgertrennung bei einem dotierten Absorber über alternierend benachbarte Emitterbereiche (gegendotiert zum Absorber) und BSF-Bereiche (hoch gleichdotiert zum Absorber) erzeugt werden. Bei den Emitter- und BSF-Bereichen handelt es sich aber um elektrisch leitende Halbleiterbereiche mit Dotierung. Bei der Herstellung sind entsprechende Dotierungs- und Strukturierungsmaßnahme erforderlich.

Aus der DE 4412 297 A1 ist es bekannt, die Rekombinationsgeschwindigkeit an der Oberfläche eines Halbleiterelements, beispielsweise p-leitendes Silizium, durch Aufbringen einer Schicht aus einem elektrischen Isolator, beispielsweise Oxide oder Nitride, auf die Oberfläche des Halbleiterelements und anschließendem Aufbringen von elektrischen Ladungen auf die Oberfläche der Isolatorschicht zu passivieren. Dabei können positive oder negative Ladungen aufgebracht werden. Dadurch wird die Dichte der Ladungsträger an den Orten einer hohen Zustandsdichte an Trap- oder Rekombinationszentren verringert. Durch Aufbringen der Ladungen entsteht im Inneren des Halbleiterelements ein elektrisches Feld, durch das die im Leitungsband befindlichen frei beweglichen Minoritätsladungsträger (Elektronen bei einem p-dotierten Halbleiter, Löcher bei einem n-dotierten Halbleiter) aus dem oberflächennahen Bereich in das Innere des Halbleiterelements gezogen werden. Die extern aufgebrachten Ladungen (z.B. durch Koronaentladung) können beispielsweise durch eine anschließend thermisch aufgewachsene Deckschicht fixiert werden. Es können auch auf beide Oberflächen des Halbleiterelements Isolationsschichten mit Ladungen aufgebracht werden, allerdings werden dabei Ladungen gleicher Polarität aufgebracht, um Lebensdauermessungen der Ladungsträger durchführen zu können.

Die Verwendung von Passivierungsschichten aus Aluminiumoxid und Siliziumnitrid mit ihren unterschiedlichen Oberflächenladungen (AIO, negativ, bzw. SiN, positiv) für Solarzellen zur Verringerung der Oberflächen-Rekombinationsrate ist aus der DE 35 36 299 A1 bekannt. Dabei werden Solarzellen mit ganzflächigem MIS-Kontakt, MIS-Inversionsschicht-Solarzellen und Solarzellen mit konventionellem pn-Übergang zur Ladungsträgertrennung beschrieben.

Die US 2004/0187916 offenbart eine Solarzelle mit rückseitigen Erhebungen, auf denen bzw. auf deren Flanken sich Passivierbereiche und erste und zweite Kontakte zum Sammeln der Ladungsträger befinden.

Aus der **VERÖFFENTLICHUNG** I von Jan Benick et al.: "Surface passivation of boron diffused emitters for high efficiency solar cells" (Proceedings PVSEC-33, San Diego, Mai 2008) ist ebenfalls die Anwendung von Al₂O₃ als Passivierungsschicht für einen diffundierten (p+)-Emitter bekannt. Es wurde eine Solarzelle Al₂O₃ / cSi (p+, Frontemitter, flächig, diffundiert) / c-Si(n, Absorber, Wafer) / SiO₂ mit c-Si(n+, BSF, rückseitige Punktkontakte, diffundiert) mit einem Wirkungsgrad von 23,2% prozessiert. Aus der **VERÖFFENTLICHUNG II** von Jan Schmidt et al.: "Atomic-layer-deposited aluminium oxide for the surface passivation of high efficiency silicon solar cells" (Proceedings PVSEC-33, San Diego, Mai 2008) ist die Struktur einer prozessierten Solarzelle mit 20,6 % Wirkungsgrad (Siliziumnitrid / cSi(n+, Frontemitter, flächig, diffundiert) / c-Si(p, Absorber, Wafer) / Al₂O₃ mit c-Si(p+, BSF, rückseitige Punktkontakte, diffundiert). In beiden Veröffentlichungen gibt es die (diffundierten) (p+)- bzw. (n+)- Emitter- bzw. BSF-Bereiche, die dann (über die Ausbildung eines "konventionellen" p+/n bzw. n+/p Emitter-Kontakts an der Emitter-Absorber-Grenzfläche bzw. über die Ausbildung eines p+/p bzw. eines n+/n BSF-Kontakts an der BSF-Absorber-Grenzfläche) die selektive "konventionelle" Ladungsträgertrennung ermöglichen.

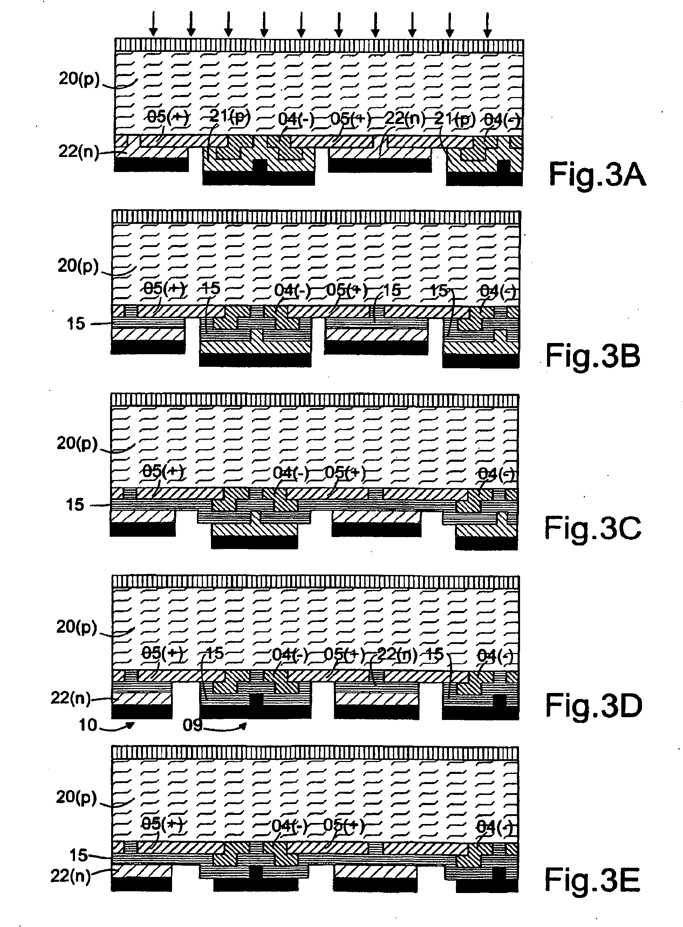

Von der Solarzelle gemäß der **VERÖFFENTLICHUNG II** geht die Erfindung als nächstliegendem Stand der Technik aus, da hier eine Solarzelle der eingangs beschriebenen, gattungsgemäßen Art offenbart wird. Es handelt sich um eine Solarzelle mit einer photoaktiven, halbleitenden Absorberschicht, in der durch im Betriebsfall in die Vorderseite der Absorberschicht einfallendes Licht überschüssige positive und negative Ladungsträger erzeugt werden. Zur Trennung der positiven und negativen Ladungsträger wird in der Absorberschicht, ein elektrisches Feld durch Bildung eines pn-Übergangs zwischen dem ganzflächigen Kontakt einer vorderseitigen Emitterschicht und eines p-dotierten Siliziumwafers erzeugt (vergleiche Figur 3 der **VERÖFFENTLICHUNG II**). Die getrennten Ladungsträger (Minoritätsladungsträger) können eine minimale effektive Diffusionslänge L_{eff}, ₘᵢₙ in der Absorberschicht zurücklegen, bevor sie rekombinieren. Weiterhin sind zur Ableitung der positiven Ladungsträger Punktkontakte als erste Kontaktelementen auf der im Betriebsfall lichtabgewandten Rückseite der Absorberschicht vorgesehen. Zur Ableitung der negativen Ladungsträger befinden sich auf der im Betriebsfall lichtzugewandten Vorderseite der Absorberschicht Kontaktstreifen als zweite Kontaktelemente. Die bekannte Solarzelle ist also beidseitig kontaktiert. Weiterhin befindet sich auf der Rückseite der Absorberschicht eine flächige Al₂O₃-Schicht als elektrisch isolierender erster Passivierbereich mit einer hohen negativen Oberflächenladung zur Anreicherung von positiven Ladungsträgern in der Absorberschicht im Kontaktbereich. Auf der Vorderseite der Solarzelle befindet sich auf der Emitterschicht noch eine flächige Siliziumnitrid-Schicht als elektrisch isolierender zweiter Passivierbereich mit einer hohen positiven Oberflächenladung zur Anreicherung von negativen Ladungsträgern in der Absorberschicht im Kontaktbereich. Die Ladungsträgertrennung bei der bekannten Solarzelle erfolgt jedoch konventionell mittels eines selektiven pn-Übergangs zwischen Emitter und Absorber.

### AUFGABENSTELLUNG

Die **AUFGABE** für die vorliegende Erfindung wird darin gesehen, eine alternative Form der Ladungsträgertrennung für die gattungsgemäße Solarzelle gemäß der **VERÖFFENTLICHUNG II** anzugeben, wobei deren Wirkungsgrad zumindest gleich oder besser sein soll. Durch die alternative Form der Ladungsträgertrennung sollen Alignment- und Strukturierungsprobleme bei der Herstellung der Solarzelle weitgehend vermieden werden. Die erfindungsgemäße LÖSUNG für diese Aufgabe ist dem Hauptanspruch zu entnehmen, vorteilhafte Weiterbildungen der Erfindung werden in den Unteransprüchen aufgezeigt und im Folgenden im Zusammenhang mit der Erfindung näher erläutert.

Bei der erfindungsgemäßen Lösung ist die gattungsgemäße Solarzelle gekennzeichnet durch
- eine alternierende benachbarte Anordnung mehrerer erster und zweiter elektrisch isolierender Passivierbereiche auf der Rückseite der Absorberschicht mit einer Dicke Lₓ von 0 < Lₓ ≤ L_{eff}, _{min,} ,
- zumindest eine zweite Kontaktöffnung in jedem zweiten elektrisch isolierenden Passivierbereichs zum Anschluss eines zweiten Kontaktelements und
- einen Abstand L_{y} zwischen jedem ersten und jedem zweiten Kontaktelement von 0< L_{y} ≤ 2 L_{eff, min}.

Mit der Erfindung wird eine rückseitenkontaktierte Solarzelle zur Verfügung gestellt, bei der die selektive Trennung photogenerierter Überschuss-Ladungsträger unter Ausnutzung der Felderzeugung durch unterschiedliche, undotierte, elektrisch isolierende Passivierschichten mit starker gegensätzlicher Oberflächenladung (positiv und negativ) erfolgt. Die elektrisch isolierenden Passivierbereiche erzeugen in ihren Kontaktbereichen zur Absorberschicht entartete oder nahezu entartete Halbleiteroberflächen gegensätzlicher Dotierung, was zur selektiven Überschuss-Ladungsträgertrennung ausgenützt wird. Zwischen benachbarten Passivierbereichen gegensätzlicher Oberflächenladung bilden sich elektrische Felder (Raumladungszonen) aus. In diesen werden die photogenerierten überschüssigen Ladungsträger getrennt und selektiv abgeleitet. Um alle erzeugten überschüssigen Ladungsträger in der Absorberschicht auch zu erreichen, weist die Absorberschicht dazu eine Dicke Lₓ von 0 < Lₓ ≤ L_{eff}, ₘᵢₙ. Damit ist gewährleistet, dass alle freien Ladungsträger auch durch die gesamte Dicke der Absorberschicht wandern können, ohne vorher zu rekombinieren. Bei einer undotierten Absorberschicht (intrinsisch) treten positive und negative überschüssige Ladungsträger gleichmäßig auf und weisen daher beide ungefähr die gleiche effektive Diffusionslänge L_{eff} auf. Bei einem dotierten Halbleiter als Absorberschicht, stellen die Dotieratome die Majoritätsladungsträger in großer Zahl, sodass deren effektive Diffusionslänge größer ist als die der geringer auftretenden Minoritätsladungsträger. Bei der Dimensionierung der Abstände ist somit immer die minimale effektive Diffusionslänge L_{eff,min} zu beachten, damit bei dotierten Absorberschichten auch die Minoritätsladungsträger sicher eingesammelt werden können.

Andere Felderzeuger zur direkten Ladungsträgertrennung als die elektrisch isolierenden Passivierschichten gegensätzlicher Oberflächenladung sind bei der Erfindung grundsätzlich nicht erforderlich. Bei der erfindungsgemäßen Solarzelle wird die Ladungsträgertrennung nicht primär über flächig bzw. punktförmig ausgeführte Heterokontaktschichten bzw. über flächig bzw. punktförmig ausgeführte diffundierte Bereiche erzeugt, sondern primär durch die beiden elektrisch isolierenden Passivierschichten gegensätzlicher Oberflächenladung bewirkt. Optional können zwar weiterhin dotierte Heteroschichten bzw. dotierte diffundierte Bereiche unterstützend (insbesondere als Kontaktelemente) verwendet werden, dies ist nun aber nicht mehr funktionsrelevant und vergrößert nur den Strukturierungs-Aufwand für den Vorteil einer geringeren Kontakt-Rekombination. Der Vorteil einer geringen Kontaktrekombination kann dann vorteilhaft auch unter Verwendung einer halbleitenden, intrinsischen, Passivierschicht ohne Strukturierungsaufwand erfolgen.

Im Vergleich zu den konventionellen strukturierten rückseitenkontaktierten Solarzellen, in denen sich rückseitig dotierte Emitter und BSF-Bereiche zur Felderzeugung zur selektiven Ladungsträgertrennung abwechseln, ist es bei der Erfindung insbesondere nicht mehr nötig, eine isolierende Passivierschicht als Spacerschicht zwischen den dotierten Emitter und BSF-Bereichen einzusetzen, was den Strukturierungsaufwand bei der Erfindung erheblich vermindert. Außerdem entfallen bei der Erfindung sämtliche Alignment-Probleme. Grundsätzlich ist die Verwendung von dotierten Halbleitern bei der Erfindung nicht erforderlich, wodurch defektärmere (intrinsische oder schwach dotierte) Absorberschichten vorteilhaft verwendet werden können.

Bei der erfindungsgemäßen Solarzelle befinden sich beide Kontaktsysteme auf der im Betriebsfall vom Lichteinfall abgewandten Rückseite der Solarzelle. In jedem ersten elektrisch isolierenden Passivierbereich ist zumindest eine Kontaktöffnung zum Anschluss eines ersten Kontaktelements mit der Absorberschicht vorgesehen. Alle ersten Kontaktelemente bilden zusammen mit entsprechenden Sammelelementen ein erstes Kontaktsystem, über das alle selektierten Überschuss-Ladungsträger einer Polarität abgeführt werden (bei dotierten Absorberschichten beispielsweise die Majoritätsladungsträger entsprechend der Dotierung). In jedem zweiten elektrisch isolierenden Passivierbereich ist zumindest eine Kontaktöffnung zum Anschluss eines zweiten Kontaktelements mit der Absorberschicht vorgesehen. Alle zweiten Kontaktelemente bilden zusammen mit entsprechenden Sammelelementen ein zweites Kontaktsystem, über das alle selektierten Ladungsträger der entgegengesetzten Polarität abgeführt werden (bei dotierten Absorberschichten beispielsweise die Minoritätsladungsträger entsprechend der Dotierung). Damit sichergestellt ist, dass auch alle photogenerierten Überschuss-Ladungsträger in den Feldeinfluss der Passivierschichten gelangen und dort getrennt zu den richtigen Kontaktelementen abgeleitet werden können, ist immer zwischen jedem erstem und jedem zweitem Kontaktelement ein Abstand L_{y} von 0< L_{y ≤} 2 L_{eff, min} vorgesehen. Je geringer der Abstand zwischen den Kontaktelementen ist, beispielsweise 0< L_{y} < L_{eff}, ₘᵢₙ, desto besser ist die Erfassung und Ableitung der separierten Überschuss-Ladungsträger über die entsprechenden Kontaktelemente. So kann sicher gewährleistet werden, dass an jeder Stelle die im Absorber generierten überschüssigen Minoritätsladungsträger, deren Sammlung erheblich schwieriger ist als die Sammlung der Majoritätsladungsträger, die Minoritätsladungsträger sammelnden Passivierbereiche bzw. Kontakte erreichen, bevor sie im Absorber rekombinieren.

Bevorzugt zeigen die der ersten und zweiten Kontaktelemente eine punkt- oder streifenförmige (dazu zählt auch gitterförmige) Ausbildung, sodass die Kontaktflächen mit der Absorberschicht, die hohe Rekombinationsgeschwindigkeiten aufweisen, weitgehend minimiert sind. Andere Ausführungsformen der Kontaktelemente sind aber ebenfalls ohne weiteres möglich. Für eine möglichst gleichmäßige, flächendeckende Überschuss-Ladungsträgersammlung ist es weiterhin vorteilhaft, wenn die Kontaktöffnungen im Bereich der Flächenschwerpunkte der ersten und zweiten Passivierbereiche angeordnet sind. Andere, beispielsweise asymmetrische Anordnungen sind aber ebenfalls möglich. Weiterhin kann pro Passivierbereich vorteilhaft auch eine Vielzahl von besonders kleinen Kontaktöffnungen vorgesehen sein. Dabei können die Kontaktöffnungen Nanoabmessungen aufweisen und stochastisch verteilt sein. Hierzu wird im speziellen Beschreibungsteil ein bevorzugtes Herstellungsverfahren beschrieben. Das Vorsehen einer Vielzahl von Kontaktöffnungen erhöht signifikant die Selektivität der Überschuss-Ladungsträgerabführung, da dann die durch die Passivierbereiche erzeugte Entartung der Absorber-Oberfläche vollständig bis in die Kontaktöffnungen hineinreichen kann.

Die metallischen Kontaktelemente bestehen bevorzugt aus zwei unterschiedlichen Metallen mit unterschiedlicher Austrittsarbeit, wobei die erforderliche Austrittsarbeit so festgelegt wird, dass der Metall/Halbeiter-Kontakt zur intrinsischen Passivierschicht (a-Si:H(i)) zu einer elektronen-anreichernden Oberfläche führt, wenn er sich auf einem Passivierbereich mit hoher negativen Oberflächenladung befindet, und zu einer Löcher anreichernder Oberfläche, wenn er sich auf einem Passivierbereich mit hoher positiver Oberflächenladung befindet. Die unterschiedliche Austrittsarbeit der metallischen Kontaktelemente unterstützt dann - ähnlich wie die dotierten Bereiche - die selektive Überschuss-Ladungsträgertrennung im Bereich des Zentrums der Kontaktöffnungen, in welches - je nach der gewählten Größe der Kontaktöffnungen - die durch die Passivierschicht erzeugten Raumladungszonen des Absorbers nicht mehr hineinreichen bzw. in ihrem Einfluss signifikant abnehmen.

Zur weiteren Verbesserung des Wirkungsgrads der Solarzelle kann vorteilhaft auch eine flächige Passivierschicht auf der Vorderseite der Absorberschicht vorgesehen sein. Diese Passivierschicht trägt nicht notwendigerweise aktiv zur selektiven Ladungsträgertrennung bei, sondern senkt die Rekombinationsrate an der Oberfläche der Substratschicht, sodass eine reine Oberflächenpassivierung erfolgt. Zudem kann vorteilhaft auch die vorderseitige Passivierschicht aus zwei unterschiedlichen isolierenden Passivierschichten mit entgegengesetzt hoher Oberflächenladung bestehen (z.B. entgegengesetzt identisch zu den zwei Passivierbereichen auf der Solarzellenrückseite), um die selektive Überschuss-Ladungsträgertrennung von vorne (Ort der hauptsächlichen Überschuss-Ladungsträger-Generation) nach hinten (Ort der Überschuss-Ladungs-Träger-Abfuhr) durch ein (hierdurch wiederum durch die isolierenden Passivierbereiche erzeugtes) eingebautes elektrisches Feld zu unterstützen. Dies kann insbesondere für Dünnschicht-Absorber relevant sein (z.B. intrinsisches, amorphes Silizium, a-Si:H(i)), in denen eine rein diffusionsgetriebene rückseitige Überschussladungsträgersammlung aufgrund ihrer relativ hohen Defektdichten nicht vorteilhaft ist. Die rückseitige Überschuss-Ladungsträgersammlung ist dann auch feldunterstützt.

Weiterhin ist es vorteilhaft, wenn zur Minimierung des rekombinationsaktiven Übergangs zwischen den metallischen Kontaktelementen und der halbleitenden Absorberschicht eine flächige oder strukturierte, elektrisch leitende, intrinsische Passivierschicht auf den ersten und zweiten Passivierbereichen vorgesehen ist. Weiterhin ist es vorteilhaft, wenn zwischen den ersten und zweiten Passiverbereichen ein schmaler, dünner elektrisch isolierender dritter Passivierbereich ohne hohe Oberflächenladung vorgesehen ist, der die notwendige Aufhebung der Entartung oder nahen Entartung an den Kanten der ersten und zweiten Passiverbereichen unterstütz und so einen Kurzschluss vermeidet.

Grundsätzlich können bei der Erfindung dotierte oder undotierte (intrinsische) Halbleitermaterialien zur Herstellung der Absorberschicht eingesetzt werden. Zur weiteren Verbesserung des Wirkungsgrades kann es bei der Verwendung von dotierten halbleitenden Absorberschichten vorteilhaft sein, wenn die metallische Kontaktierung über dotierte Homo- oder Hetero-Halbleiterkontakte erfolgt. Vorteilhaft können bei einer dotierten Absorberschicht entgegengesetzt dotierte heterogen aufgebrachte oder diffundierte Emitterschichten zumindest in den Kontaktöffnungen derjenigen ersten oder zweiten Passivierbereiche vorgesehen sein, die eine zur Absorberdotierung gleiche Oberflächenladung aufweisen. Bei einer p-dotierten Absorberschicht handelt es sich somit um den elektrisch isolierenden zweiten Passivierbereich mit einer hohen positiven Oberflächenladung, in dessen Kontaktöffnungen sich die negativ dotierten Emitterschichten befinden. Bei einer n-dotierten Absorberschicht befänden sich somit positiv dotierte Emitterschichten in den Kontaktöffnungen der elektrisch isolierenden ersten Passivierbereiche mit einer hohen negativen Oberflächenladung. Weiterhin können zur dotierten Absorberschicht gleich dotierte heterogene oder lokal oder flächig diffundierte BSF-Schichten zumindest in den Kontaktöffnungen der ersten oder zweiten Passivierbereiche mit zur Absorberdotierung gegensätzlicher Oberflächenladung vorgesehen sein. Bei einer p-dotierten Absorberschicht handelt es sich somit um den elektrisch isolierenden ersten Passivierbereich mit einer hohen negativen Oberflächenladung, in dessen Kontaktöffnungen sich die positiv dotierten BSF-Schichten (Back Surface Field) befinden. Bei einer n-dotierten Absorberschicht befänden sich hingegen negativ dotierte BSF-Schichten in den Kontaktöffnungen der elektrisch isolierenden zweiten Passivierbereiche mit einer hohen positiven Oberflächenladung.

Für eine verbesserte Kontaktierung der in den Kontaktöffnungen angeordneten Heterokontakte durch die ersten und zweiten Kontaktelemente ist es weiterhin vorteilhaft, wenn sich die Emitterschichten und/oder BSF-Schichten von den Kontaktöffnungen her auf den ersten und/oder zweiten Passivierbereichen erstrecken, ohne sich allerdings gegenseitig zu berühren. Auf den erstreckten Gebieten können dann größerflächige Kontaktelemente angeordnet werden. Analog können auch zusätzliche Emitter- und/oder BSF-Schichten auf der zuvor aufgebrachten elektrisch leitenden Passivierschicht aufgebracht sein, die dann in die Kontaktöffnungen hineinreicht. Bei einer Aufbringung von sowohl zusätzlichen Emitter- als auch BSF-Schichten dürfen sich diese nicht berühren.

Die Kontakte können bei der Solarzelle nach der Erfindung also idealerweise über punkt- oder streifenförmige, rekombinationsarme Heterokontakte, die jedoch nicht zwingend zur Erzeugung einer Raumladungszone beitragen, realisiert werden (z.B. a-Si:H(i), intrinsisches, amorphes hydrogeniertes Silizium). Gelingt es insbesondere, den Durchmesser der Punktkontakte oder die Breite der Streifenkontakte kleiner als die zweifache mittlere Raumladungszonenweite der jeweiligen Überschuss-Ladungsträger zu wählen, so wirkt das elektrische Feld des jeweiligen Passivierbereichs auch in den Bereichen der Kontakte selektiv trennend. Ist der Durchmesser oder die Breite größer, so findet die selektive Ladungsträgertrennung nur in den Übergangs-Randbereichen der Raumladungszonen statt. Im Falle einer intrinsisch gewählten photoaktiven Absorberschicht kann dies jedoch durch eine Beschichtung der Kontakte mit einer intrinsischen, leitfähigen Heteropassivierschicht kompensiert werden. Im Innenbereich des Punkt- oder Streifenkontakts ist der Kontakt zur Absorberschicht dann passiviert, im Randbereich findet die selektive Überschuss-Ladungsträger-Abführung statt. Im Falle einer dotierten photoaktiven Absorberschicht können für den Fall, dass die Strukturgrößen der Kontakte größer als die zweifache mittlere Raumladungszonenweite sind, die Kontaktöffnungen der Überschuss-Minoritäten über zusätzliche, extern aufgebrachte dotierte Heterokontaktschichten oder über lokale Diffusion so modifiziert werden, dass die Halbleiteroberfläche des Absorberschicht dort auch zur selektiven Überschuss-Ladungsträger-Abführung beiträgt. Die punkt- oder streifenförmigen Kontakte werden dann idealerweise über rekombinationsarme Heterokontakte realisiert, die nicht zwingend zur Erzeugung einer Entartung analog zur von der jeweiligen Passivierschicht erzeugten Entartung der Halbleiteroberfläche beitragen müssen (z.B. eine Schicht aus intrinsischen, amorphen Silizium, die wiederum metallisch ohmsch kontaktiert ist). Es können aber natürlich auch (jedoch unvorteilhaft rekombinationsaktivere) konventionelle Kontaktierungen für die Kontakte eingesetzt werden, die dann die selektive Ladungsträgertrennung der Passivierbereiche unterstützen.

Wird insbesondere z.B. hydrogeniertes, intrinsisches, amorphes Silizium (a-Si:H(i)) als leitfähige Passivierschicht zur Punktkontaktierung eines z.B. idealerweise intrinsischen Silizium-Wafers als Photoabsorber eingesetzt, so ist bekannt, dass ultradünnes (z.B. 30 nm dickes) a-Si:H(i) als leitende Passivierschicht ähnlich gut passiviert wie die besten zur Zeit bekannten isolierenden Passivierschichten (z.B. SiO₂, Si₃N₄, Al₂O₃). Gemäß der Erfindung wird z.B. a-Si:H(i) zur Kontaktierung der punkt- oder streifenförmigen Kontaktierungen des Wafers verwendet. Da die isolierenden Passivierbereiche bereits für die selektive Ladungsträgertrennung sorgen, ist es jetzt nicht mehr notwendig, weitere hochdotierte (rekombinationsaktive) Halbleiterschichten zur selektiven Ladungsträgertrennung auf oder unter die intrinsische a-Si:H(i)-Schicht aufzubringen. Insbesondere wird dann nur eine leitende Passivierschicht benötigt und nicht zwei verschiedenartige, wie bisher im Stand der Technik üblich (eine Passivierschicht zur Abführung der Überschuss-Elektronen und eine Passivierschicht zur Abführung der Überschuss-Löcher). Je nachdem, über welcher isolierenden Passivierschicht sich das a-Si:H(i) befindet, führt es entweder Überschuss-Elektronen oder Überschuss-Löcher ab. Dies reduziert den Strukturierungsaufwand erheblich, insbesondere in der Ausführungsform einer rückseitenkontaktierten Solarzelle.

Weiterhin können bei der Solarzelle nach der Erfindung Durchführungen der Passivierschichten zur im Betriebsfall dem Lichteinfall zugewandten Vorderseite der Solarzelle bzw. der Absorberschicht angeordnet sein. Die auf der Vorderseite der Absorberschicht aufgebrachte isolierende Passivierschicht trägt dann vorteilhaft auch zur selektiven Überschuss-Ladungsträgertrennung bei, die vorderseitig gesammelten Überschuss-Ladungsträger werden über die Durchführungen an ein rückseitig angeordnetes Kontaktsystem abgeführt, welches analog zu dem eben beschriebenem ausgeführt ist. Bevorzugt kann die Solarzelle nach der Erfindung dann gekennzeichnet sein durch eine dotierte Absorberschicht, eine Durchführung der Kontaktöffnungen in den ersten oder zweiten Passivierbereichen mit zur Absorberdotierung gleicher Oberflächenladung bis auf die Vorderseite der Absorberschicht und eine Belegung der durchgeführten Kontaktöffnungen und der Vorderseite der Absorberschicht zwischen den durchgeführten Kontaktöffnungen mit dem Material der ersten oder zweiten Passivierbereiche. Bei einer p-dotierten Absorberschicht sind dementsprechend die Kontaktöffnungen der zweiten Passivierbereiche mit positiver Oberflächenladung durch die Absorberschicht durchgeführt und mit dem Material der zweiten Passivierbereiche belegt. Bei einer n-dotierten Absorberschicht sind hingegen die Kontaktöffnungen der ersten Passivierbereiche mit negativer Oberflächenladung durch die Absorberschicht durchgeführt und mit dem Material der ersten Passivierbereiche belegt.

Wie oben schon in einigen Beispielen ausgeführt, kann bei der Solarzelle nach der Erfindung bevorzugt intrinsisches oder dotiertes Silizium als Material für die Absorberschicht, Siliziumnitrid als Material für die elektrisch isolierenden ersten Passivierbereiche mit einer hohen positiven Oberflächenladung, Aluminiumoxid als Material für die elektrisch isolierenden zweiten Passivierbereiche mit einer hohen negativen Oberflächenladung und Aluminium oder TCO (Transparentes leitfähiges Oxid)/Aluminium als Material für die ersten und zweiten Kontaktelemente eingesetzt werden. Für die elektrisch leitende intrinsische Passivierschicht kann bevorzugt wasserstoffterminiertes amorphes Silizium (a-Si:H) als Material eingesetzt werden.

### AUSFÜHRUNGSBEISPIELE

Ausbildungsformen der Solarzelle nach der Erfindung mit Passivierschichten gegensätzlicher Oberflächenladung zur Felderzeugung zur Trennung der überschüssigen Ladungsträger werden nachfolgend anhand der schematischen Figuren zum weiteren Verständnis der Erfindung näher erläutert (keine maßstäbliche Darstellung). Dabei wird die Solarzelle nach der Erfindung in Schnitten gezeigt in
- **FIGUR 1A**: als Prinzipdarstellung mit schematisch eingezeichneten elektrischen Feldern in der halbleitenden Absorberschicht, die durch die beiden isolierenden Passivierbereiche erzeugt werden,
- **FIGUR 1B**: eine räumliche Prinzipdarstellung der Banddiagramme,
- **FIGUR 2A**: mit intrinsischem Absorber, drittem elektrisch isolierenden Passivierbereich (ungeladen) und beide Kontaktierungen über intrinsische Heteroschicht, strukturiert,
- **FIGUR 2B**: mit intrinsischem Absorber und beide Kontaktierungen über intrinsische Heteroschicht, unstrukturiert,
- **FIGUR 2C**: gemäß Figur 2B im Querschnitt mit interdigitierenden Kontaktierungen,
- **FIGUR 3A**: mit dotiertem Absorber und beide Kontaktierungen über dotierte Heteroschicht, strukturiert,
- **FIGUR 3B**: mit dotiertem Absorber und beide Kontaktierungen über dotierte Heteroschicht und intrinsische Heteroschicht, strukturiert,
- **FIGUR 3C**: mit dotiertem Absorber und beide Kontaktierungen über dotierte Heteroschicht und intrinsische Heteroschicht, unstrukturiert,
- **FIGUR 3D**: mit dotiertem Absorber und Minoritäts-Kontaktierung über dotierte Heteroschicht und intrinsische Heteroschicht, strukturiert und Majoritäts-Kontaktierung über intrinsische Heteroschicht, strukturiert,
- **FIGUR 3E**: mit dotiertem Absorber und Minoritäts-Kontaktierung über dotierte Heteroschicht und intrinsische Heteroschicht, unstrukturiert und Majoritäts-Kontaktierung über intrinsische Heteroschicht, unstrukturiert,
- **FIGUR 4A**: mit dotiertem Absorber und beide Kontaktierungen über konventionelle Diffusion,
- **FIGUR 4B**: mit dotiertem Absorber und Minoritäts-Kontaktierung über konventionelle Diffusion und intrinsische Heteroschicht, strukturiert und Majoritäts-Kontaktierung über intrinsische Heteroschicht, strukturiert,
- **FIGUR 5A**: mit dotiertem Absorber und Pseudo-Durchkontaktierungen, Minoritäts-Kontaktierung über intrinsische Heteroschicht und lokale Diffusion, strukturiert und Majoritäts-Kontaktierung über intrinsische Heteroschicht, strukturiert (erster Querschnitt),
- **FIGUR 5B**: mit dotiertem Absorber und Pseudo-Durchkontaktierungen, Minoritäts-Kontaktierung über intrinsische Heteroschicht und lokale Diffusion, strukturiert und Majoritäts-Kontaktierung über intrinsische Heteroschicht, strukturiert (zweiter Querschnitt),
- **FIGUR 5C**: gemäß Figuren 5A, 5B und 6A, 6B im Querschnitt mit interdigitierenden Kontaktierungen,
- **FIGUR 6A**: mit dotiertem Absorber und Pseudo-Durchkontaktierungen, Minoritäts-Kontaktierung über intrinsische Heteroschicht und flächige Diffusion, strukturiert und Majoritäts-Kontaktierung über intrinsische Heteroschicht, strukturiert (erster Querschnitt),
- **FIGUR 68**: mit dotiertem Absorber und Pseudo-Durchkontaktierungen, Minoritäts-Kontaktierung über intrinsische Heteroschicht und flächige Diffusion, strukturiert und Majoritäts-Kontaktierung über intrinsische Heteroschicht, strukturiert (zweiter Querschnitt),

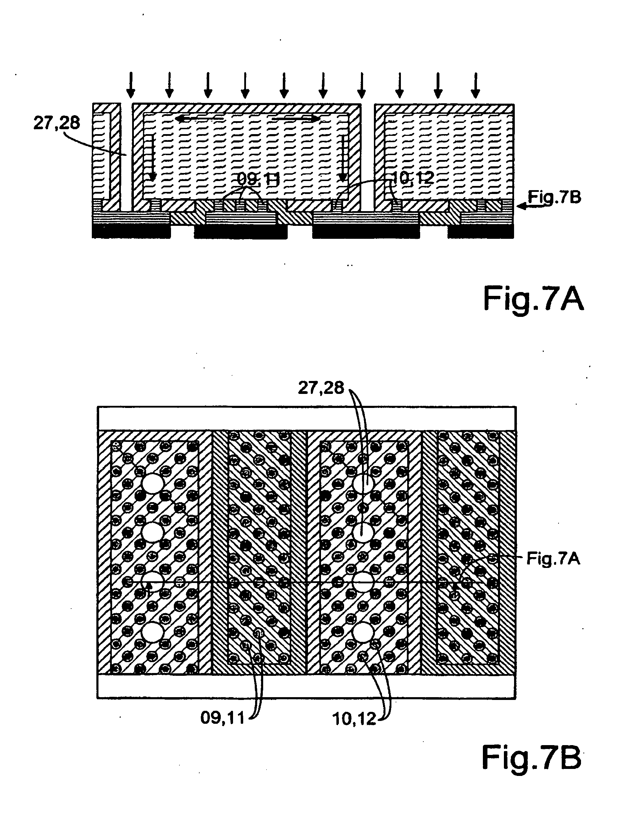

- **FIGUR 7A**: mit intrinsischem oder dotiertem Absorber und Pseudo-Durchkontaktierungen und vielen Punkt-Kontaktierungen über eine intrinsische Heteroschicht, strukturiert,
- **FIGUR 7B**: gemäß Figur 7A im Querschnitt mit vielen Kontaktierungen,

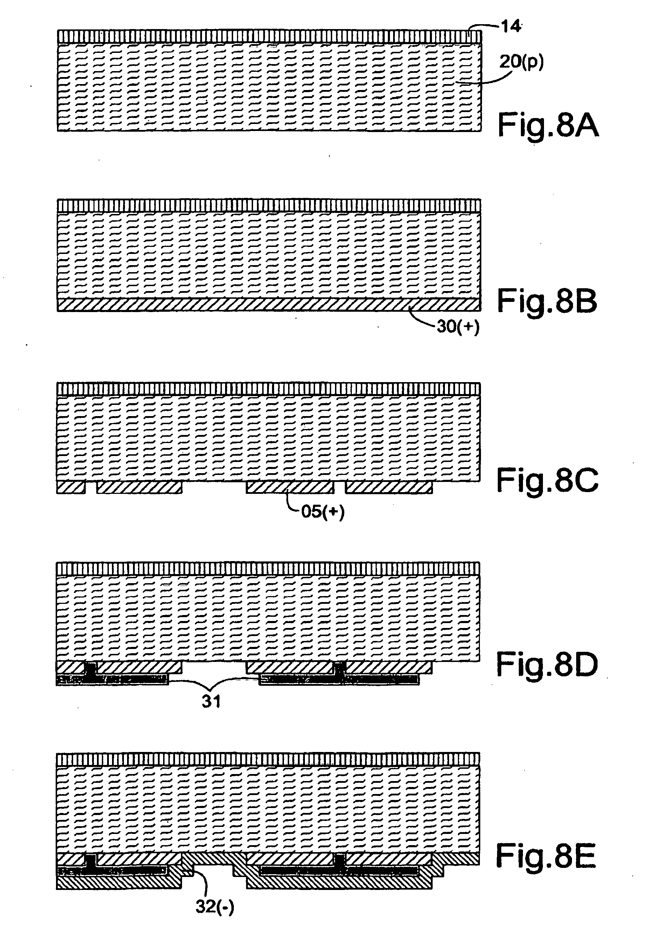

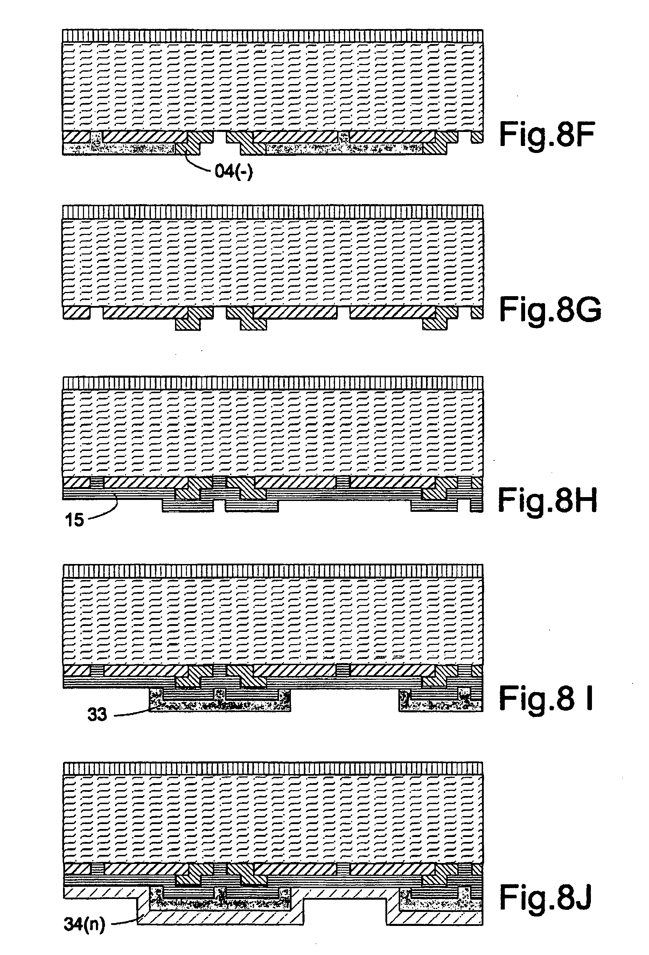

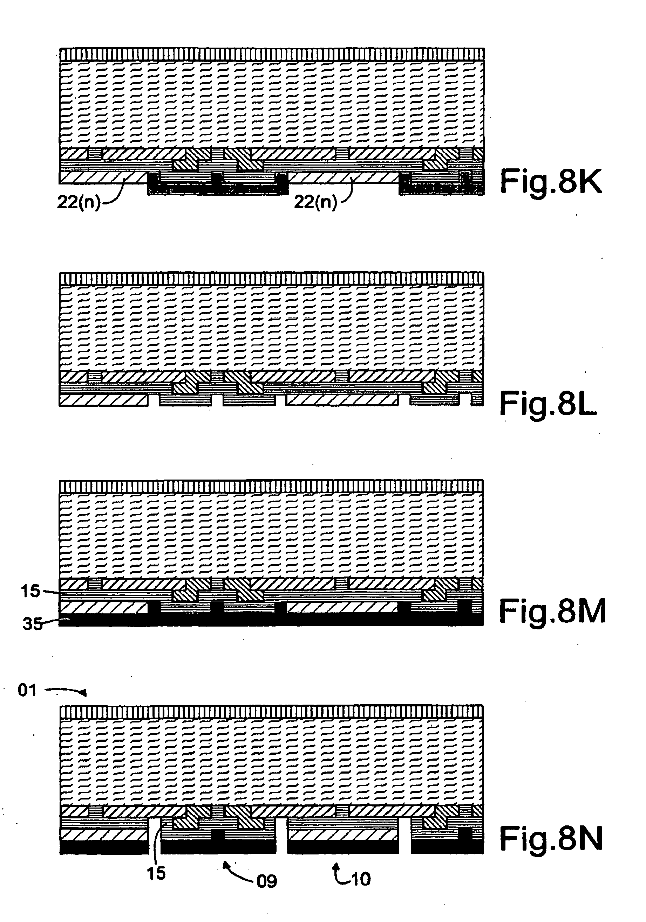

- **FIGUREN 8 A..N**: ein konventionelles Herstellungsverfahren mit grober Strukturierung der Passivierbereiche,

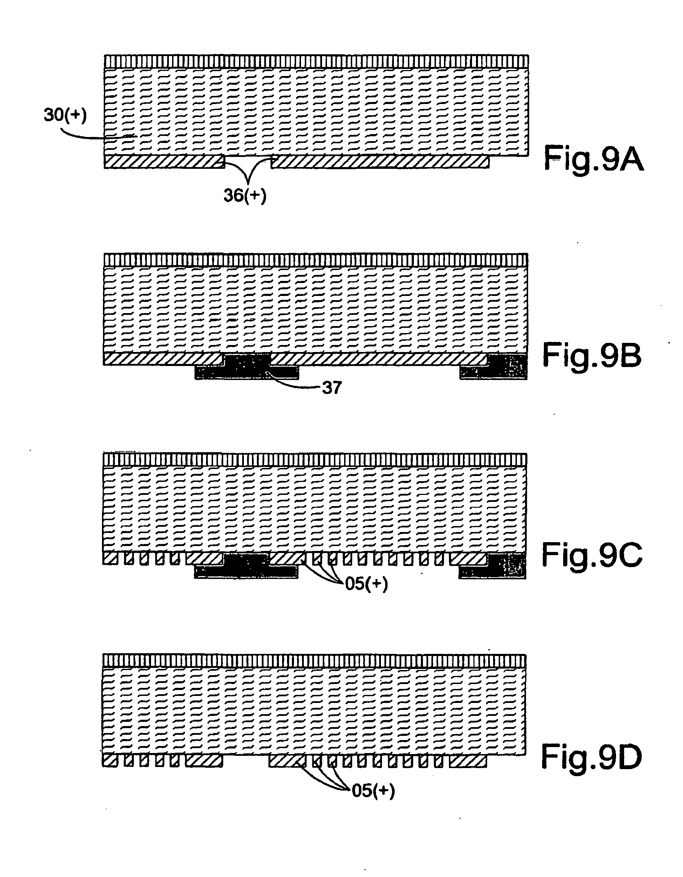

- **FIGUREN 9 A..D**: ein konventionelles Herstellungsverfahren mit feiner Strukturierung der Passivierbereiche und

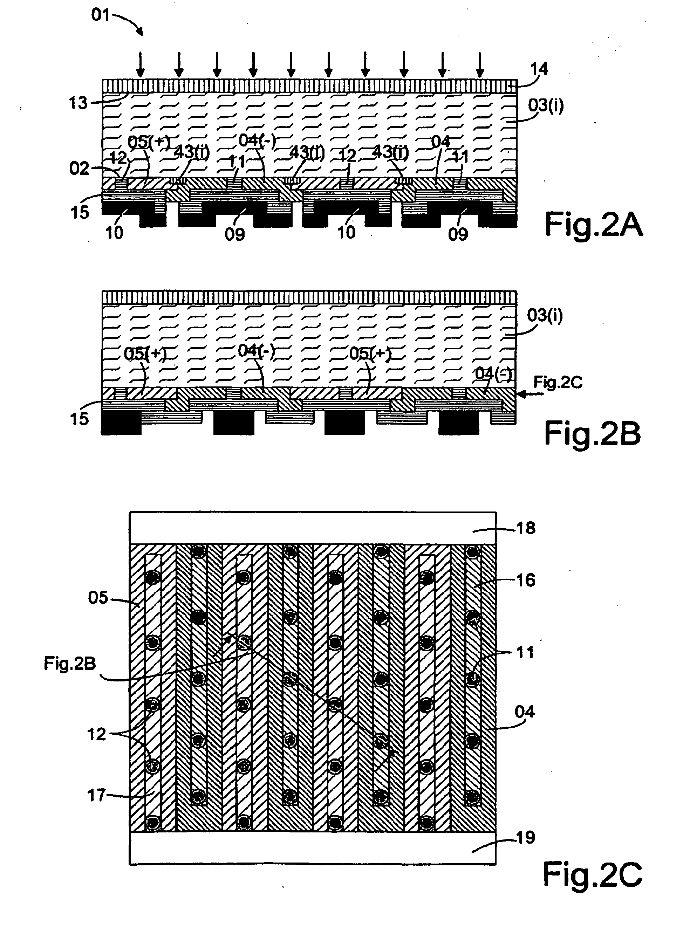

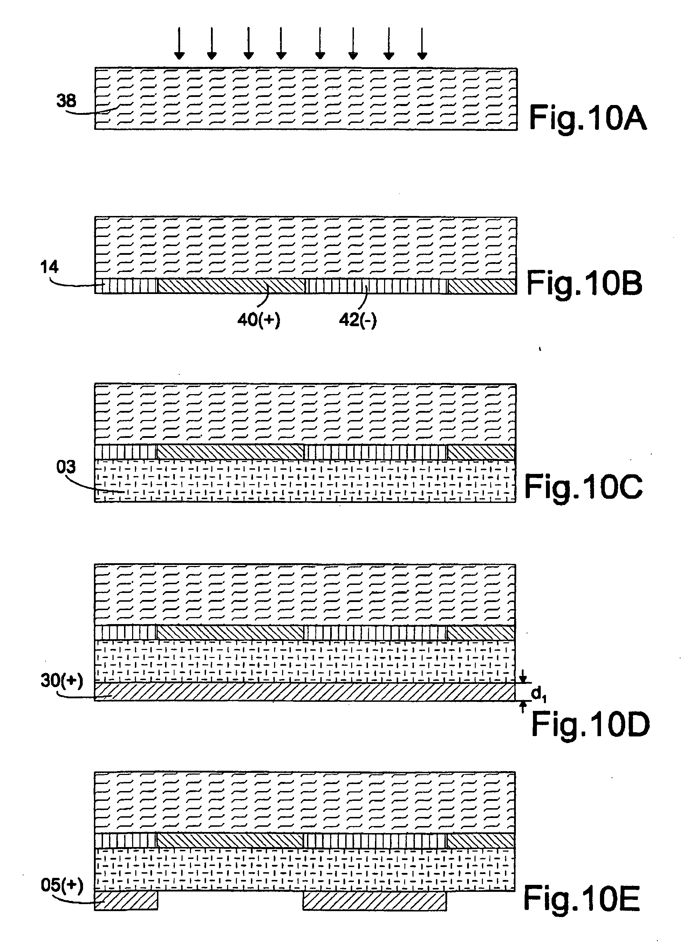

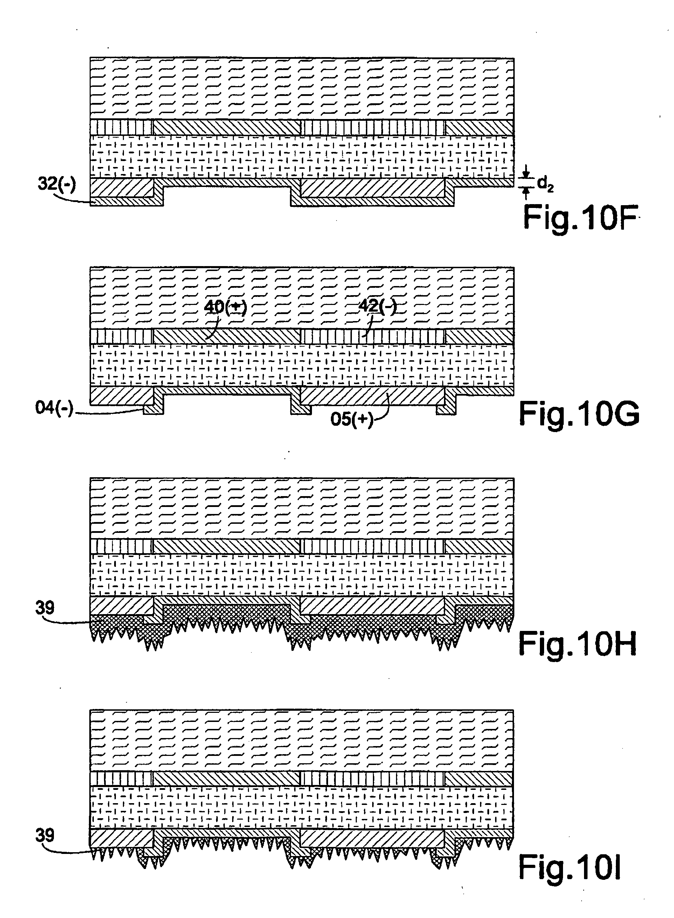

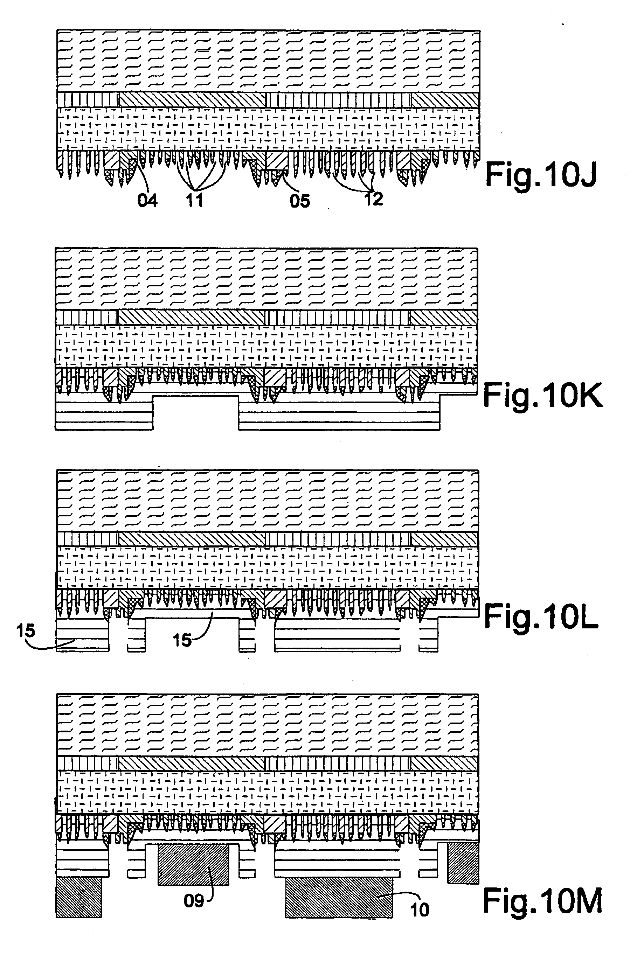

- **FIGUREN 10 A..M**: ein neues Herstellungsverfahren einer Solarzelle gemäß Figur 2A mit feiner Strukturierung.

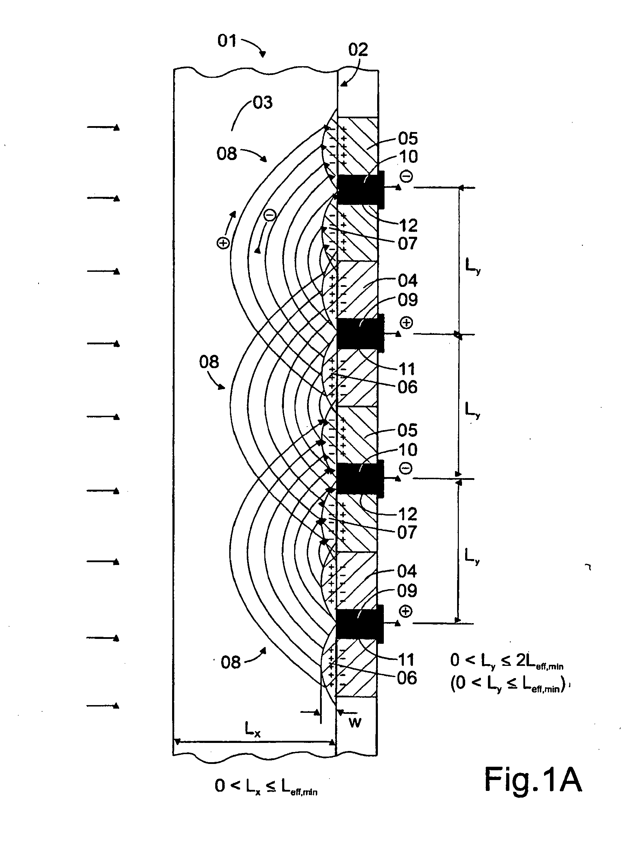

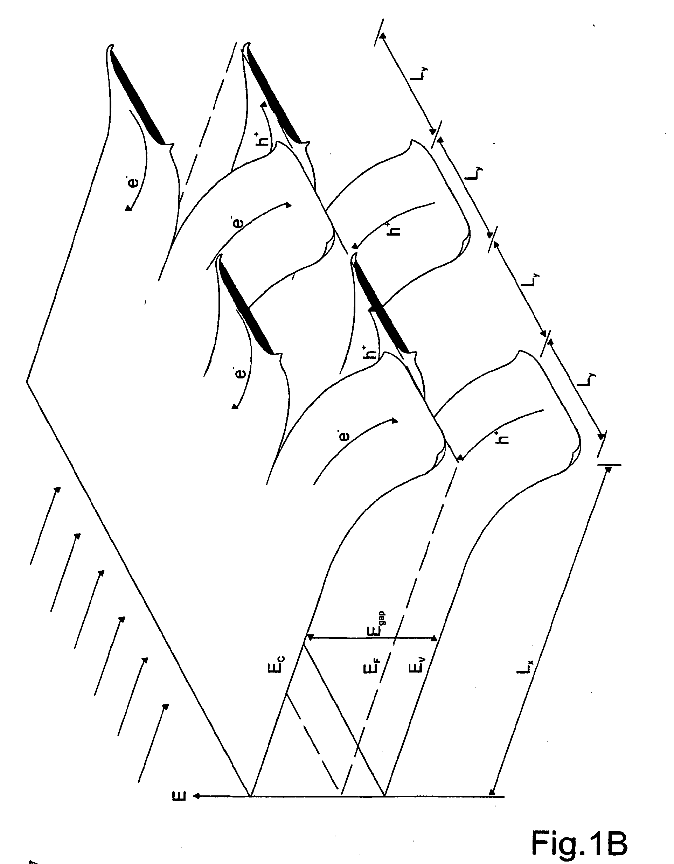

Die **FIGUR** 1 **A** zeigt eine Solarzelle **01** nach der Erfindung in ihrem grundsätzlichen Aufbau im Querschnitt. Auf der im Betriebsfall lichtabgewandten (Lichteinfall siehe Pfeile) Rückseite **02** der Solarzelle **01** sind abwechselnd auf einer halbleitenden Absorberschicht **03,** die intrinsisch (03) oder positiv (20) oder negativ dotiert sein kann, erste Passivierbereiche **04** mit einer hohen negativen Oberflächenladung und zweite Passivierbereiche **05** mit einer hohen positiven Oberflächenladung angeordnet. Weiterhin sind die sich ausbildenden Raumladungszonen **06** unterhalb der ersten Passivierbereiche **04** mit hoher negativer Oberflächenladung (gezeigt ist auch die Anreicherung von positiven Ladungen in der Oberfläche der Absorberschicht **03)** und die Raumladungszonen **07** unterhalb der zweiten Passivierbereiche **05** mit hoher positiver Oberflächenladung (gezeigt ist auch die Anreicherung von negativen Ladungen in der Oberfläche der Absorberschicht **03)** und die sich bildenden elektrischen Felder **08** eingezeichnet (keine maßstäbliche Darstellung). Zu erkennen ist, dass alle in der Absorberschicht **03** generierten überschüssigen Ladungsträger entsprechend ihrer Polarität zu ersten Kontaktelementen **09** (Ableitung positiver überschüssiger Ladungsträger) in den ersten Passivierbereichen **04** und zu zweiten Kontaktelementen **10** (Ableitung negativer überschüssiger Ladungsträger) in den zweiten Passivierbereichen **05** wandern können.

Damit alle Ladungsträger aus der gesamten Absorberschicht **03** auch die Raumladungszonen **06, 07** (mit einer Weite **W)** erreichen, ist es erforderlich, dass die Dicke **Lₓ** der Absorberschicht **03** kleiner oder gleich der kleinsten, in der Absorberschicht **03** auftretenden effektiven Diffusionslänge **L_{eff,min}** ist (0 < Lₓ ≤ L_{eff,min}). Die ersten und zweiten Kontaktelemente **09, 10** sind in ersten Kontaktöffnungen **11** und zweiten Kontaktöffnungen **12** angeordnet. Damit alle photogenerierten Ladungsträger in den Raumladungszonen **06, 07** die ersten und zweiten Kontaktelemente **09, 10** erreichen können, ist es erforderlich, dass die Kontaktöffnungen **11, 12** einen Abstand L_{y} zueinander haben, der kleiner oder gleich dem Doppelten der kleinsten, in der Absorberschicht **03** auftretenden effektiven Diffusionslänge **L_{eff,min}** ist (0< L_{y} ≤ 2 L_{eff, min}). Eine besonders sichere Ableitung der Ladungsträger ergibt sich, wenn **L_{y}** kleiner oder gleich der effektiven Diffusionslänge **L_{eff,min}** ist (0< L_{y} ≤ L_{eff}, ₘᵢₙ). Im gewählten Ausführungsbeispiel sind die Kontaktöffnungen **11, 12** jeweils in den Flächenschwerpunkten der ersten und zweiten Passivierbereiche **04, 05** angeordnet.

In der **FIGUR 1** **B** ist die Wirkungsweise der Passivierbereiche **04, 05,** die elektrisch nichtleitend sind und aus undotierten, nichthalbeitenden Materialien mit hoher positiver bzw. negativer Oberflächenladung bestehen, anhand der Banddiagramme des Absorbers mit dem Energieverlauf **(E_{V}** Valenzband, **E_{F}** Fermi-Niveau, **E_{C}** Leitungsband) über die Dicke **Lₓ** der Absorberschicht **03** und dem Abstand **L_{y}** der Kontaktöffnungen **11,12** dargestellt. Durch die hohen Oberflächenladungen (Defektzustände) der Passivierbereiche **04, 05** erfolgt in der Oberfläche der Absorberschicht **03** eine Anreicherung von jeweils gegensätzlich geladenen Überschuss-Ladungsträgern, sodass keine Oberflächen-Rekombination für die anderen Überschuss-Ladungsträger gegensätzlicher Polarität möglich ist (gut passivierte Oberfläche mit geringer Rekombinationsgeschwindigkeit). Die Bandverbiegung geht bis zur Entartung (keine anderen Überschuss-Ladungsträger erreichen mehr die Oberfläche) bzw. bis nahezu zur Entartung (wenige andere Überschuss-Ladungsträger erreichen noch die Oberfläche). Zu erkennen ist die jeweilige Entartung, d.h. Überschuss-Ladungsträger mit derselben Ladung (e⁻ für Elektronen, negative Polarität, h⁺ für Löcher, positive Polarität) wie die entsprechenden Passivierbereiche **04, 05** erreichen nicht die zugehörige Oberfläche der Absorberschicht **03.** Entlang der Kanten, wo sich die beiden Passivierbereiche **04, 05** mit der entgegengesetzt hohen Oberflächenladungsdichte berühren, ist die Entartung aufgehoben, da in der Nähe der Kante dann die resultierende Netto-Gesamtladung gering ist (Differenz der positiven und negativen Oberflächenladung). Der Feldverlauf erfolgt also derart, dass Überschuss-Elektronen bzw. -Löcher in den "Zentren" der Passivierbereiche **04, 05** an der Halbleiteroberfläche der Absorberschicht 03 gesammelt werden. Es kommt dann insbesondere nicht zu einer internen Rekombination von Überschuss-Elektronen und -Löchern an den Kanten.

Die notwendige Aufhebung der Entartung oder nahen Entartung an den Kanten kann noch dadurch verstärkt werden, dass ein dünner, streifiger, elektrisch isolierender dritter Passivierbereich **43** ohne eine hohe Oberflächenladung (z.B. SiO₂) zwischen den beiden Passivierbereichen **04, 05** mit hoher Oberflächenladung angeordnet ist, vergleiche **FIGUR 2A****.**

Die nachfolgenden **FIGUREN** zeigen verschiedene Ausführungsformen der Solarzelle **01** nach der Erfindung hinsichtlich des Schichtenaufbaus und der Ausgestaltung der beiden Kontaktsysteme. In einzelnen **FIGUREN** nicht gezeigte Bezugszeichen sind den vorangehenden **FIGUREN** und der Beschreibung zu entnehmen.

Es ist bekannt, dass ultradünnes (z.B. 30 nm dickes) a-Si:H(i) als leitende Passivierschicht ähnlich gut passiviert wie die besten zur Zeit bekannten isolierenden Passivierschichten (z.B. SiO₂, Si₃N₄, Al₂O₃). Deshalb kann bei der Erfindung beispielsweise hydrogeniertes, intrinsisches, amorphes Silizium (a-Si:H(i)) als elektrisch leitfähige Passivierschicht zur Punktkontaktierung eines beispielsweise intrinsischen Siliziumwafers als photoaktive Absorberschicht **03** eingesetzt werden. Weiterhin kann a-Si:H(i) auch zur Kontaktierung der punkt-(oder streifenförmigen) Kontaktelemente Absorberschicht verwendet werden. Dadurch, dass die isolierenden Passivierschichten bereits für die selektive Ladungsträgertrennung sorgen, ist es bei der Solarzelle nach der Erfindung nicht mehr notwendig, weitere, hochdotierte und damit rekombinationsaktive Halbleiterschichten zur selektiven Ladungsträgertrennung auf oder unter die intrinsische a-Si:H(i) Schicht aufzubringen. Insbesondere wird dann nur noch eine leitende Passivierschicht benötigt und nicht zwei verschiedenartige, wie bisher üblich (eine zur Abführung der Überschuss-Elektronen und eine zur Abführung der Überschuss-Löcher). Je nachdem, über welchem isolierenden Passivierbereich (negative oder positive Oberflächenladung) sich das a-Si:H(i) befindet, führt es dann entweder Überschuss-Elektronen oder Überschuss-Löcher ab. Dies reduziert den Strukturierungsaufwand erheblich, insbesondere in der Ausführungsform einer rückseitenkontaktierten Solarzelle gemäß der **FIGUREN 2A, 2B, 2C****.**

In den **FIGUREN 2A, 2B** ist im schematischen Querschnitt (nicht maßstabsgerecht) eine Solarzelle **01** nach der Erfindung dargestellt. Auf der im Betriebsfall dem Lichteinfall (Pfeile) zugewandten Vorderseite **13** ist weiterhin eine flächige Passivierschicht **14** (beispielsweise SiN, z.B. Si₃N₄, oder SiO₂) zur guten Oberflächenpassivierung der intrinsischen Absorberschicht **03** (beispielsweise intrinsischer Siliziumwafer) angeordnet, die jedoch nicht zwingend zur Ladungsträgertrennung beträgt. Auf der Rückseite **02** der Absorberschicht **03** sind alternierend elektrisch isolierende erste Passivier-bereiche **04** mit hoher negativer Oberflächenladung (beispielsweise AIO, z.B. Al₂O₃) und zweite Passivierbereiche **05** mit hoher positiver Oberflächenladung (beispielsweise SiN) angeordnet. Auf beiden Bereichen **04, 05** ist wiederum eine elektrisch leitende, intrinsische Passivierschicht **15** (beispielsweise aus intrinsischem, amorphem Silizium, a-Si(i)) **(****FIGUR 2A****:** strukturiert, **FIGUR 2B****:** flächig) zur Verringerung der Rekombinationsrate angeordnet. Die elektrisch leitende, intrinsische Passivierschicht **15** kontaktiert die Absorberschicht **02** über punktförmige Kontaktöffnungen **11, 12.** Entsprechend der Strukturierung der elektrisch leitenden, intrinsischen Passivierschicht **15** sind die ersten Kontaktelemente **09** (beispielsweise Al oder TCO/Al) und die zweiten Kontaktelemente **10** (beispielsweise Al oder TCO/Al) größer **(****FIGUR 1A****)** oder kleiner **(****FIGUR 2B****)** ausgebildet.

In der **FIGUR 2A** ist noch zusätzlich ein dünner, streifiger, elektrisch isolierender dritter Passivierbereich **43** ohne eine hohe Oberflächenladung (z.B. SiO₂) zwischen den beiden Passivierbereichen **04, 05** vorgesehen. Dieser dient der sicheren Unterstützung der notwendigen Aufhebung der Entartung oder nahen Entartung an den Kanten der beiden elektrisch isolierenden Passivierbereiche **04, 05,** vergleiche **FIGUR 1** **B.**

Die **FIGUR 2C** zeigt einen Längsschnitt entlang des seitlichen Pfeils in der **FIGUR 2B** auf die ersten und zweiten Passivierbereiche **04, 05** mit den Kontaktelementen **09, 10.** Zu erkennen ist, dass sich in jedem Passivierbereich **09, 10** jeweils mehrere punktförmige Kontaktöffnungen **11, 12** (hier gebildet durch die elektrisch leitende, intrinsische Passivierschicht **15)** und verbindende Kontaktstreifen **16, 17** (hier gebildet aus Aluminiumstreifen) in der Ausführungsform von interdigitierenden Metallisierungen befinden, die jeweils in seitlichen Sammelschienen **18,19** zusammengeführt werden. In der **FIGUR 2C** ist wiederum die Schnittlinie für den Querschnitt gemäß **FIGUR 2B** aufgezeigt.

Wird ein dotierter Siliziumwafer (dotierte Ladung: Majoritäts-Ladungsträger oder Majoritäten, gegensätzliche Ladung: Minoritäts-Ladungsträger oder Minoritäten) als photoaktive dotierte Absorberschicht **20** eingesetzt und ist die Strukturgröße der Kontaktelemente **09, 10** größer als die zweifache mittlere Weite W der Raumladungszonen **06, 07,** so können nur noch die Überschuss-Majoritäten über eine Punktkontaktierung mit einer leitfähigen, intrinsischen Heterokontaktschicht (z.B. a-Si:H(i)) problemfrei abgeführt werden. Je nach Größe der Punktkontaktierungen ist die Halbleiteroberfläche der dotierten Absorberschicht **20** an den Minoritäts-Punktkontakten zwar in den Randbereichen noch nahe der Entartung in Inversion (Anreicherung von Minoritäten an der Halbleiteroberfläche, in Richtung der Mitte der Punktkontaktierungen geht sie dann aber von der Inversion über in eine Flachbandsituation (Anreicherung von Majoritäten an der Halbleiteroberfläche aufgrund der Absorberdotierung), sodass der Kontakt dann nicht mehr selektiv für die Abführung der Überschuss-Minoritäten des Absorbers wirkt. Die Halbleiter-oberfläche der Majoritäts-Kontakte hingegen geht dann von einer Akkumulation (Anreicherung von Majoritäten an der Halbleiteroberfläche) bis zu einer Flachbandsituation (Anreicherung von Majoritäten an der Halbleiteroberfläche aufgrund der Absorberdotierung), so dass dieser Kontakt also weiterhin selektiv für die Abführung der Überschuss-Majoritäten des Absorbers bleibt.

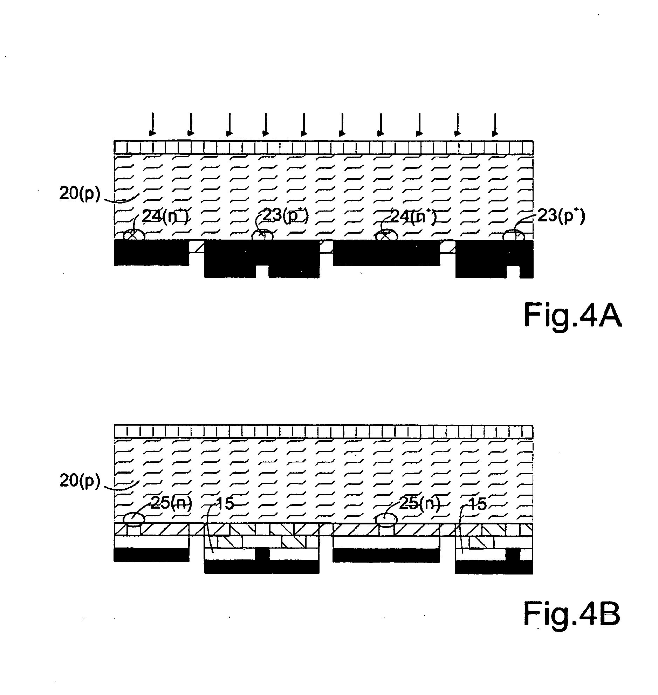

Entweder sind also die Punktkontakte sehr klein zu gestalten (und damit die Anzahl der Punktkontaktierungen sehr groß zu wählen (möglich durch spezielle Fertigungsverfahren (z.B. Interferenz-Verfahren oder auch durch ein Verfahren zur Erzeugung von stochastisch angeordneten Nano- Punktkontakten, dieses wird weiter unten beschrieben) oder es sind dotierte Heterokontaktschichten (siehe **FIGUREN 3A....3F****)** oder dotierte, konventionell diffundierte Bereiche (siehe **FIGUREN 4A....4B****)** zumindest zur Abführung der Überschuss-Minoritäten einzusetzen. Wird auf die dotierten Schichten zur Abführung der Überschuss-Majoritäten verzichtet, so lässt sich auch hier der Strukturierungsaufwand bei der Solarzelle nach der Erfindung erheblich reduzieren. Zudem genügt im Falle einer konventionellen Diffusion eine weniger starke (und damit auch weniger rekombinationsaktive) Dotierung.

In der **FIGUR 3A** ist eine dotierte Absorberschicht **20** (z.B. p-dotiert) mit einer flächigen Passivierschicht **14** auf der Vorderseite **13** und auf der Rückseite **02** alternierend angeordneten isolierenden ersten und zweiten Passivierbereichen **04, 05** dargestellt. Auf den ersten Passivierbereichen **04** (negative Oberflächenladung) ist eine Hetero-BSF-Schicht **21** (Back Surface Field) mit zur Absorberschicht **20** gleicher Dotierung (hier dann p-dotiert) und auf den zweiten Passivierbereichen 05 (positive Oberflächenladung) ist eine heterogene Emitterschicht **22** mit zur dotierten Absorberschicht **20** gegensätzlicher Dotierung (hier dann n-dotiert) angeordnet. Der sich zwischen der dotierten Absorberschicht **20** und der gegendotierten heterogenen Emitterschicht **22** ausbildende pn-Übergang dient jedoch in der Hauptsache der verbesserten Ladungsabfuhr und trägt nur untergeordnet zur Ladungsträgertrennung bei. Auf der heterogenen BSF-Schicht **21** sind erste Kontaktelemente **09** zur Abfuhr der positiven überschüssigen Ladungen und auf der heterogenen Emitterschicht **22** sind zweite Kontaktelemente **10** zur Abfuhr der negativen überschüssigen Ladungen angeordnet.

In der **FIGUR 3B** ist zusätzlich auf den ersten und zweiten Passivierbereichen **04, 05** eine elektrisch leitende, intrinsische Passivierschicht **15** angeordnet **(****FIGUR 3B****:** strukturiert, **FIGUR 3C****:** flächig), In der **FIGUR 3D** ist neben der elektrisch leitenden, intrinsischen Passivierschicht **15 (****FIGUR 3D****:strukturiert,** **FIGUR 3E****:** flächig) nur die heterogene Emitterschicht **22** vorgesehen. Die heterogene BSF-Schicht **21** ist nicht vorhanden, was den Strukturierungs-aufwand verringert.

Die **FIGUR 4A** entspricht der **FIGUR 3A****,** wobei in der **FIGUR 4A** diffundierte BSF-Schichten **23** (mit hoher Gleichdotierung zur dotierten Absorberschicht **20)** und diffundierte Emitterschichten **24** (mit hoher Gegendotierung zur dotierten Absorberschicht 20) vorgesehen sind. Die **FIGUR 4B** entspricht der **FIGUR 3D****,** wobei in der **FIGUR 4B** nur lokal diffundierte Emitterschichten **25** (mit einfacher Gegendotierung zur dotierten Absorberschicht **20)** vorgesehen sind.

Bei allen angegebenen Konfigurationen (intrinsischer Absorber, dotierter Absorber mit dotierten Heterokontaktschichten oder konventionell dotierten diffundierten Bereichen) ist der Absorber primär mit flächig abgeschiedenen isolierenden Passivierschichten (mit hoher unterschiedlicher Oberflächenladung) passiviert, diese übernehmen die selektive Überschuss-Ladungsträgertrennung. Die Überschuss-Ladungsträger werden dann über punkt- oder streifenförmige Kontaktöffnungen (über eine Heterokontaktschicht, alle Figuren außer **FIGUREN 4A, 4B****,** oder über diffundierte Bereiche, **FIGUREN 4A, 4B****)** abgeführt. Durch die Anordnung von zwei elektrisch isolierenden Passivierschichten in Bereichen auf der Absorberrückseite wird jegliche Alignment-Problematik vermieden, da sich die isolierenden Passivierschichten auch problemlos teilweise überlappen können. Werden konventionell diffundierte Bereiche durch den Einsatz von Heteroschichten vermieden, so kann damit die Kontaktrekombination signifikant reduziert werden: einerseits bleibt der Solarzellen-Absorber rekombinationsarm (keine rekombinationsaktiven, hochdotierten diffundierten Bereiche), andererseits verringern die geeignet gewählten Band-Offsets des Heterokontakts die Kontaktrekombination.

Hybride Kombinationen (ein Kontakttyp ist über eine konventionelle Diffusion ausgeführt, der andere über Heteroschichten) sind natürlich ebenso denkbar, werden hier aber nicht explizit ausgeführt.

Der Wirkungsgrad dieser aufgezeigten Solarzellenstrukturen nach der Erfindung kann also im Vergleich zu den bekannten rückseitenkontaktierten Homo-Solarzellen einen signifikanten Anstieg bei gleichzeitiger erheblicher Reduzierung des Strukturierungsaufwands aufweisen. Auch im Vergleich mit bisher bekannten rückseitenkontaktierten Hetero-Solarzellen Konzepten ist der Strukturierungsaufwand erheblich reduziert: Es müssen nicht zwei verschiedene, strukturierte Heterokontakt-Schichten, sondern im Idealfall nur eine unstrukturierte Heterokontaktschicht aufbracht werden. Aufgrund der durch die Strukturierung zu erwartenden Grenzflächenschädigung der a-Si:H/c-Si Grenzfläche und der besseren Passivier-Wirkung einer intrinsischen a-Si:H Schicht im Vergleich zu einer intrinsisch/dotierten a-Si:H Doppelschicht ist auch hier ein deutlich höherer Solarzellen-Wirkungsgrad zu erwarten.

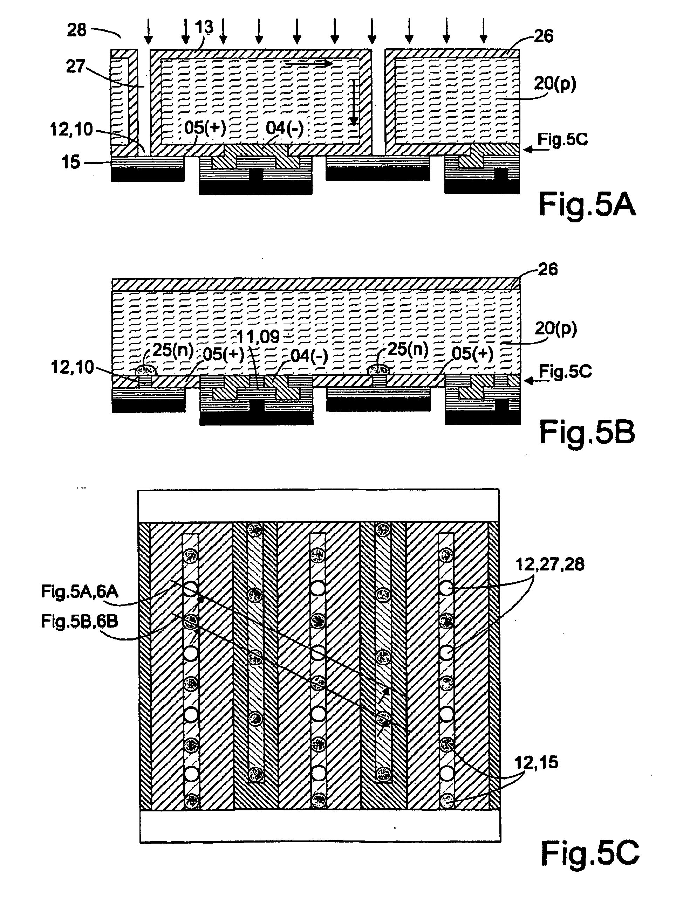

Bei der Solarzelle nach der Erfindung sind auch "Pseudo-Emitter-Wrap-Through"-Strukturen denkbar (vergleiche **FIGUREN 5A...F****).** Diese Strukturen können vorteilhaft dann eingesetzt werden, wenn ein dotierter Photoabsorber (z.B. dotierter c-Si Wafer) mit verhältnismäßig schlechter Absorberlebensdauer verwendet wird, sodass die rückseitige Sammlung der photogenerierten Überschuss-Minoritäten problematisch ist.

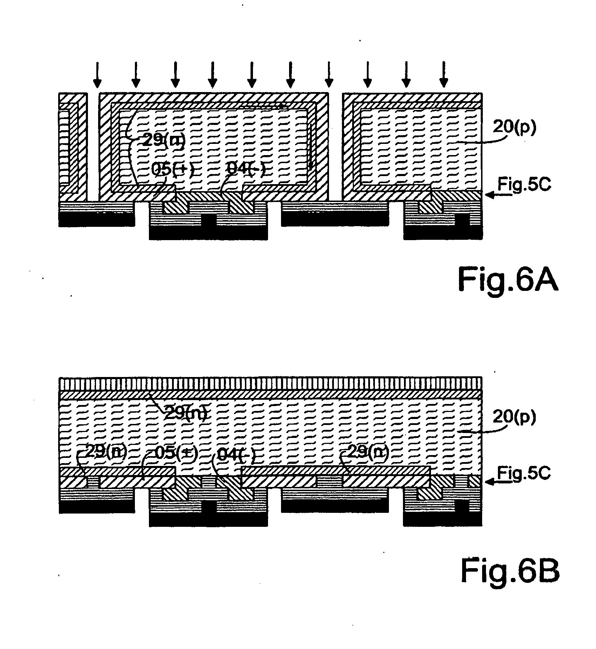

Der Photoabsorber wird dann vorderseitig mit einer isolierenden Passivierschicht mit hoher Oberflächenladung des gleichen Vorzeichens wie der Photoabsorber beschichtet (also z.B. im Falle eines p-dotierten Photoabsorbers eine Passivierschicht mit hoher positiven Oberflächenladung). Über zusätzliche "Pseudo-Durchkontaktierungen", also einfachen Durchgangslöchern im Photoabsorber, die mit demselben Material der vorderseitigen Passivierschicht gefüllt werden, entstehen nahezu entartete Minoritäts-Ladungsträger Halbleiter-Oberflächen. Die Minoritäten werden dann vorderseitig gesammelt und entlang der Vorderseite (an der entarteten Halbleiteroberfläche) zu den Durchkontaktierungen geleitet, entlang dieser (ebenfalls an der entarteten Halbleiteroberfläche) diese dann auf die Rückseite des Photoabsorbers geleitet werden. Dort werden sie dann von dem bereits beschriebenen Kontaktsystem gesammelt (vergleiche **FIGUREN 5A...C****).** Sollte die hierfür benötigte Querleitfähigkeit des reinen Absorbermaterials nicht ausreichen, so kann dies natürlich noch über eine konventionelle, flächige Diffusion verstärkt werden (vergleiche **FIGUREN 6A..B****).**

Die **FIGUR 5A** zeigt auf der Vorderseite **13** der dotierten Absorberschicht **20** (hier p-dotiert) eine flächige Passivierschicht **26** mit derselben Oberflächenladung wie der zweite Passivierbereich **05** mit hoher positiver Oberflächenladung. Vorteilhaft wird identisches Material, beispielsweise Siliziumnitrid, verwendet. Im gewählten Ausführungsbeispiel sind die Kontaktlöcher **12** der zweiten Passivierbereiche **05** mit hoher Oberflächenladung als Durchführungen **27** bis auf die Vorderseite **13** der Absorberschicht **20** durchgeführt. Auch die Durchführungen sind mit einer Passivierung mit derselben Oberflächenladung wie die zweiten Passivierbereiche **05** belegt. Vorteilhaft wird auch hier identisches Material verwendet. Es ergeben sich Pseudo-Durchkontaktierungen **28.** Dabei ist nicht jedes Kontaktloch **12** durchgeführt. Die jeweils anderen Kontaktlöcher **12** weisen wiederum eine diffundierte Emitterschicht **25** mit zur Absorberschicht **20** gegensätzlicher Dotierung auf (vergleiche **FIGUR 4B****).** Der Wanderweg der Minoritätsladungsträger ist durch Pfeile in der Absorberschicht 20 dargestellt. In der **FIGUR 5C** ist wiederum eine Aufsicht an der mit Pfeil gekennzeichneten Stelle in den **FIGUREN 5A, 5C** Stelle dargestellt (vergleiche **FIGUR 2C****).** Eingezeichnet sind die Schnittebenen für die **FIGUREN 5A** und **5B****.** Zu erkennen sind die ungefüllten Kontaktlöcher **12** bzw. Durchführungen **27** und die mit der elektrisch leitenden, intrinsischen Passivierschicht **15** gefüllten Kontaktlöcher **12.** Bei einer n-dotierten Absorberschicht ergeben sich analog umgekehrte Verhältnisse. In allen Ausführungsformen tragen aber alle gebildeten pn-Übergänge nicht hauptsächlich zur Ladungsträgertrennung bei. Diese wird im Wesentlichen durch die gegensätzlich geladenen ersten und zweiten Passivierbreichen **04, 05** erreicht.

Die **FIGUREN 6A** und **6B** zeigen einen analogen Aufbau zu den Figuren **5A** und **5B****,** hier ist allerdings die zur Absorberschicht **20** normal gegendotierte Emitterschicht **29** flächig diffundiert. Die **FIGUR 5C** trifft auch auf die **FIGUREN 6A, 6B** zu.

Die **FIGUREN 7A** und **7B** zeigen analoge Ausführungsformen zu den **FIGUREN 5A** und **5C****,** allerdings jetzt mit einer Vielzahl von punktförmigen ersten Kontaktelementen **09** (in Kontaktöffnungen **11)** und punktförmigen zweiten Kontaktelementen **10** (in Kontaktöffnungen **12)** sowie mehreren Durchkontaktierungen **28** (in Durchführungen **27).**

Der Vollständigkeit sollen hier auch beidseitig kontaktierte Solarzellenstrukturen (ein Kontaktsystem auf der Vorderseite, eines auf der Rückseite der Solarzelle) nach dem Prinzip der Erfindung (Ladungsträgertrennung im Wesentlichen durch die gegensätzlich geladenen ersten und zweiten Passivierbereiche) erwähnt werden (nicht skizziert). Diese Strukturen haben jedoch den Nachteil, dass durch die vorderseitig angeordnete leitende Passivierschicht und eventuell weitere vorderseitig angeordnete Schichten die Photoabsorption in diesen Schichten nicht zur Überschuss-Ladungsträger-Generation im Photoabsorber beiträgt. Es wäre hier dann also eine vorderseitige Solarzellenstrukturierung vorzunehmen, was aber vorteilhafterweise auf der Solarzellenrückseite erfolgt, um bei gleichem Aufwand die Abschattung durch das vorderseitige Kontaktsystem zu vermeiden. Sinnvoll sind diese Strukturen nur dann, wenn die Qualität des Photoabsorbers zu gering ist, um rückseitig zu sammeln (die hauptsächlich vorderseitig generierten Überschuss-Ladungsträger rekombinieren dann auf dem Weg zur Solarzellenrückseite).

Am Beispiel der Solarzelle **01** gemäß **FIGUR 3D** wird ein geeignetes koventionelles Herstellungsverfahren in den **FIGUREN 8A** bis **8N** aufgezeigt.
**FIGUR 8A**
   Bereitstellen der Absorberschicht **20** (beispielsweise Silizium-Wafer, p-dotiert), vorderseitige (und eventuell rückseitige) Texturierung (nicht gezeichnet), vorderseitige Passivierung der Absorberschicht **20** durch Aufbringen der flächigen Passivierschicht **14.**
**FIGUR 8B**
   Rückseitige ganzflächige Deposition einer isolierenden Passivierschicht 30 mit positiver Oberflächenladung.
**FIGUR 8C**
   Strukturierung der Passivierschicht **30** mit positiver Oberflächenladung zur Bildung der zweiten Passivierbereiche **05** mit positiver Oberflächenladung.
**FIGUR 8D**
   Aufbringen einer Maskierung **31** auf die zweiten Passivierbereiche **05**
**FIGUR 8E**
   Rückseitige, ganzflächige Deposition einer isolierenden Passivierschicht **32** mit negativer Oberflächenladung.
**FIGUR 8F**
   Strukturierung der Passivierschicht **32** mit negativer Oberflächenladung zur Bildung der ersten Passivierbereiche **04** mit negativer Oberflächenladung.
**FIGUR 8G**
   Entfernung der Maskierung **31.**
**FIGUR 8H**
   Rückseitige, ganzflächige Deposition der elektrisch leitfähigen, intrinsischen Passivierschicht **15** als intrinsische Heterokontaktschicht.
**FIGUR 8I**
   Aufbringen einer Maskierung 33 auf die elektrisch leitfähige, intrinsische Passivierschicht **15.**
**FIGUR 8J**
   Rückseitige, ganzflächige Deposition einer Emitterschicht **34** mit zur Absorberschicht **20** gegensätzlicher Dotierung (hier n-dotiert) als Heterokontaktschicht.
**FIGUR 8K**
   Strukturierung der Emitterschicht **34** zur Bildung der Emitterbereiche **22.**
**FIGUR 8L**
   Entfernung der Maskierung **33.**
**FIGUR 8M**
   Rückseitige, ganzflächige Deposition einer Kontaktschicht **35.**
**FIGUR 8N**
   Strukturierung der ganzflächigen Kontaktschicht **35** und der leitfähigen Passivierschicht **15** zur Erzeugung der ersten Kontaktelemente **09** und der zweiten Kontaktelemente **10.**

Die Strukturierung der isolierenden Passivierschichten **30** und **32** kann im Falle großer Strukturgrößen via Ink-Jet-Verfahren oder Laser-Strukturierung (Strukturierungs-Limit etwa 10 µm) erfolgen. Dies stellt im Falle von waferbasierten Solarzellen (typische Strukturgrößen im Bereich der Waferdicke, also zwischen 100 und 300 µm) kein Problem dar. Im Falle kleiner Strukturgrößen, wie dies im Falle von Dünnschichtsolarzellen erforderlich ist (typische Strukturgrößen im Bereich der Absorberdicke, also zwischen 500 nm und 10 µm), kann die Strukturierung z.B. photolithographisch (Strukturierungs-Limit von etwa 100 nm bis zurzeit etwa 40 nm) erfolgen. Beispielhaft wird die entsprechende Strukturierung zur Bildung der zweiten Passivierbereiche 05 allgemein aufgezeigt (anstelle der **FIGUR 8C****):**
**FIGUR 9A**
   Grobe Strukturierung der Passivierschicht **30** mit positiver Oberflächenladung zur Bildung grober Passivierbereiche **36**
**FIGUR 9B**
   Aufbringen einer Maskierung **37** auf die groben Passivierbereiche **36**
**FIGUR 9C**
   Feine Strukturierung der groben Passivierbereiche **36** über Photolack und Laser-Interferenz zur Bildung der Passivierbereiche **05** mit positiver Oberflächenladung in feiner Strukturierung
**FIGUR 9D**
   Entfernen der Maskierung **37.**

Die Strukturierung der Kontaktöffnungen **11,12** kann entweder ebenfalls via Ink-Jet-Verfahren oder Laser-Strukturierung erfolgen (für Kontaktöffnungen mit einem Durchmesser >10 µm), oder aber mittels eines bevorzugten Verfahrens zur stochastischen Ausbildung von Nanokontakten, wie dies im folgenden noch näher ausgeführt wird, da bei der Erfindung keine Alignment-Problematiken auftreten. Mit dem beschriebenen Verfahren können Nanolöcher mit einem Durchmesser von etwa 500 nm-1 µm durch Ätzen einer strukturierten Matrize, die beispielsweise aus ZnO besteht, in stochastischer Verteilung erzeugt und für die Kontaktelemente **09, 10** genutzt werden.

Das bevorzugte vorteilhafte spezielle Verfahren nach der Erfindung wird am Beispiel einer Solarzelle **01** gemäß Figur 3D mit Kontaktöffnungen **11, 12** mit Nanoabmessungen in einem Dünnschichtaufbau auf einem Superstrat **40** erläutert:
**FIGUR 10A**
   Bereitstellen eines Superstrats **38** (z.B. Glas), der Lichteinfall im Betriebsfall ist durch Pfeile angedeutet.
**FIGUR 10B**
   Ganzflächige Deposition der vorderseitigen flächigen Passivierschicht **14** (z.B. SiO₂, SiN, AIO). Dabei zeigt die Passivierschicht **14** alternierend angeordnete Passivierflächen **40, 42** hoher Oberflächenladung gegensätzlicher Polarität, die entgegengesetzt zu den Passivierbereichen **04, 05** angeordnet sind. Durch die entsprechend aufgebauten elektrischen Felder werden Überschuss-Ladungsträgertrennung und -transport unterstützt.
**FIGUR 10C**
   Ganzflächige Deposition der Absorberschicht **03** (z.B. a-Si:H(i)).
**FIGUR 10D**
   Ganzflächige Deposition der isolierenden Passivierschicht **30,** im Beispiel mit hoher positiver Oberflächenladung (z.B. SiN), mit einer entsprechend der Ätzrate gewählten Schichtdicke **d₁.**
**FIGUR 10E**
   Bereichs-Strukturierung der zweiten isolierenden Passivierschicht **30** (ohne Durchkontaktierungen) zur Bildung der zweiten Passivierbereiche **05.**
**FIGUR 10F**
   Ganzflächige Deposition der isolierenden Passivierschicht **32,** im Beispiel mit hoher negativer Oberflächenladung (z.B. AIO), mit einer entsprechend der Ätzrate gewählten Schichtdicke **d₂.**
**FIGUR 10G**
   Bereichs-Strukturierung der ersten isolierenden Passivierschicht **32** zur Bildung der ersten Passivierbereiche **04.**
   **ERZEUGUNG VON STOCHASTISCH VERTEILTEN NANO-KONTAKTÖFFNUNGEN**
**FIGUR 10H**
   Ganzflächige Deposition einer Matrize **39** (z.B. ZnO) und anschließende Strukturierung der Matrize **39,** beispielsweise durch Ätzen.
**FIGUR 10I**
   Partielles Abätzen der Matrize **39,** bis diese stochastisch teilweise ganz abgetragen ist.
**FIGUR 10J**
   Selektives Ätzen (im Plasma) der Matrize **39.** Das Ätzen greift die Matrize **39** aufgrund der Materialwahl (z.B. Zinkoxid) nicht an, die ersten und zweiten Passivierschichten 30, 32 (z.B. SiN, AIO) jedoch schon. Hierdurch entstehen bei geeignet gewählter Ätzdauer Kontaktöffnungen **11, 12** (siehe **FIGUR** 1) mit Nanoabmessungen (Durchmesser im Bereich von 500 nm bis 2 µm) in den ersten und zweiten Passivierbereichen **04, 05** (die Schichtdicken **d₁, d₂** der beiden Passivierschichten **30, 32** wurden entsprechend gewählt).
**FIGUR 10K**
   Ganzflächige Deposition der leitfähigen, intrinsischen Passivierschicht **15** (z.B. a-Si:H(i))
**FIGUR 10L**
   Isolierung der intrinsischen Passivierschicht **15** auf den ersten und zweiten Passivierbereichen **04, 05** durch Laserstrukturierung und
**FIGUR 10M**
   Deposition der metallischen Kontaktelemente **09, 10** aus zwei verschiedenen Metallen mit unterschiedlicher Austrittsarbeit in Abhängigkeit von der Polarität der abzuleitenden Überschuss-Ladungsträger.

### GEEIGNETE MATERIALIEN UND PARAMETER FÜR DIE SOLARZELLE NACH DER ERFINDUNG:

- Absorberschicht: alle zur Zeit verwendeten Absorberschichten für Solarzellen, z.B. intrinsisches oder p- oder n-dotiertes hydrogenisiertes, amorphes Silizium, a-Si:H(i), a-Si:H(p), a-Si:H(n), intrinsisches oder p-oder n- dotiertes mikrokristallines Silizium, µc-Si(i), µc-Si(p), µc-Si(n), intrinsisches oder p- oder n-dotiertes polykristallines Silizium, polyc-Si(i), polyc-Si(p), polyc-Si(n), intrinsisches oder p- oder n-dotiertes kristallines Silizium, c-Si(i), c-Si(p), c-Si(n), CadmiumTellurid, CdTe, KupferlndiumSelenid, CISe, KupferIndiumGalliumSelenid, CIGSe, KupferIndiumSulfid, CIS
- erster Passivierbereich: alle isolierenden Passivierschichten mit derart hoher negativen Oberflächenladung, dass eine oder nahezu eine Entartung an der Absorber-Oberfläche resultiert (bei waferbasierten c-Si Solarzellen mit intrinsischem Absorber entspricht dies etwa einer negativen Oberflächenladung > 10¹¹ cm⁻², bei waferbasierten c-Si Solarzellen mit p-dotiertem Absorber (z.B. Na=1,5·10¹⁶ cm⁻³ ) entspricht dies etwa einer negativen Oberflächenladung > 4.10¹² cm⁻²). Ein solches Material ist z.B. Aluminiumoxid Al₂O₃ (Oberflächenladung etwa 1,3·10¹³ cm⁻²).
- zweiter Passivierbereich .: alle elektrisch isolierenden Passivierschichten mit derart hoher positiven Oberflächenladung, dass eine oder nahezu eine Entartung an der Absorber-Oberfläche resultiert (bei waferbasierten c-Si Solarzellen mit intrinsischem Absorber entspräche dies etwa einer positiven Oberflächenladung > 10¹¹ cm⁻², bei waferbasierten c-Si Solarzellen mit p-dotiertem Absorber (z.B. Na=1,5·10¹⁶ cm⁻³) entspricht dies etwa einer positiven Oberflächenladung > 2·10¹² cm⁻²). Ein solches Material ist z.B. Siliziumnitrid, SiNₓ (Oberflächenladung etwa 2·10¹² cm⁻²)_{.}
- dritter Passivierbereich: alle elektrisch isolierenden Passivierschichten ohne hohe Oberflächenladung, beispielsweise SiO₂
- flächige Passivierschicht: SiO₂, Al₂O₃, SiNₓ, a-Si:H(i)
- leitende Passivierschicht: intrinsisches hydrogenisiertes, amorphes Silizium a-Si:H(i)
- Emitterschicht: gegendotiert zur Absorberschicht: p- oder n-dotiertes Silizium, c-Si(p), c-Si(n), heterogen abgeschiedenes p- oder n- dotiertes hydrogenisiertes amorphes Silizium, a-Si:H(p), a-Si:H(n), heterogen abgeschiedenes p- oder n-dotiertes mikrokristallines Silizium, µc-Si:H(p), µc-Si:H(n), heterogen abgeschiedenes Cadmiumsulfid, CdS, transparent leitfähige Oxide (ZnO, ITO, n-dotiert)
- BSF-Schicht: hoch gleichdotiert zur Absorberschicht: p- oder n-dotiertes Silizium, c-Si(p), c-Si(n), heterogen abgeschiedenes p- oder n- dotiertes hydrogenisiertes amorphes Silizium, a-Si:H(p), a-Si:H(n), heterogen abgeschiedenes p- oder n-dotiertes mikrokristallines Silizium, µc-Si:H(p), µc-Si:H(n), transparent leitfähige Oxide (ZnO, ITO, n-dotiert)
- Kontaktelemente: Metalle, z.B. Aluminium, Molybdän, Chrom, Silber, Nickel, Titan, Palladium oder transparent leitfähige Oxide (ZnO, ITO)

Dicke Lₓ der Absorberschicht
- waferbasierte c-Si Solarzellen: typischerweise zwischen 100 µm und 300 µm
- Dünnschichtsolarzellen: typischerweise zwischen 500 nm und 10 µm
minimale Diffusionslänge L_{eff, min} ≥ Lₓ
mittlerer Abstand L_{y} der Kontaktöffnungen ≤ Lₓ
mittlere Weite W der Raumladungszone im Absorber, die durch die isolierenden Passivierbereiche erzeugt wird, :
- waferbasierte c-Si Solarzellen: intrinsischer Absorber: 25 µm dotierter Absorber (z.B. Na=1,5·10¹⁶ cm⁻³): 300 nm

### BEZUGSZEICHENLISTE

- **01**: Solarzelle
- **02**: Rückseite von 01
- **03**: halbleitende Absorberschicht, intrinsisch
- **04**: elektrisch isolierender, erster Passivierbereich mit hoher Oberflächenladung einer Polarität, z.B. negativ
- **05**: elektrisch isolierender, zweiter Passivierbereich mit hoher Oberflächenladung gegensätzlicher Polarität, z.B. positiv
- **06**: Raumladungszone von 04
- **07**: Raumladungszone von 05
- **08**: elektrisches Feld
- **09**: erstes Kontaktelement zur Ableitung von Überschuss-Ladungsträgern einer Polarität, z.B. positiv

- **10**: zweites Kontaktelement zur Ableitung von Überschuss-Ladungsträger gegensätzlicher Polarität, z.B. negativ
- **11**: erste Kontaktöffnung für 09 (punkt- oder streifenförmig)
- **12**: zweite Kontaktöffnung für 10 (punkt- oder streifenförmig)
- **13**: Vorderseite von 01
- **14**: flächige Passivierschicht auf 13
- **15**: elektrisch leitende intrinsische Passivierschicht auf 02
- **16**: Kontaktstreifen für 09
- **17**: Kontaktstreifen für 10
- **18**: Sammelschiene für 16, 09
- **19**: Sammelschiene für 17, 10

- **20**: halbleitende Absorberschicht (Absorber), normal dotiert (p/n)
- **21**: Hetero-BSF-Schicht (heterogen, normal gleichdotiert zu 20)
- **22**: Emitterschicht (heterogen, normal gegendotiert zu 20)
- **23**: Hetero-BSF-Schicht (diffundiert, normal gleichdotiert zu 20)
- **24**: Emitterschicht (lokal diffundiert, hoch gegendotiert zu 20)
- **25**: Emitterschicht (lokal diffundiert, normal gegendotiert zu 20)
- **26**: flächige Passivierschicht mit hoher Oberflächenladung einer Polarität, z.B. positiv
- **27**: Durchführung
- **28**: Pseudo-Durchkontaktierung
- **29**: Emitterschicht (flächig diffundiert, normal gegendotiert zu 20)

- **30**: ganzflächige, elektrisch isolierende Passivierschicht mit hoher Oberflächenladung einer Polarität, z.B. positiv
- **31**: Maskierung für 29
- **32**: ganzflächige, elektrisch isolierende Passivierschicht mit hoher Oberflächenladung gegensätzlicher Polarität, z.B. negativ
- **33**: Maskierung für 32
- **34**: rückseitige Emitterschicht (heterogen, normal gegendotiert zu 20)
- **35**: Kontaktschicht
- **36**: grober Passivierbereich (hohe positive oder negative Oberflächenladung)
- **37**: Maskierung für 36
- **38**: Superstrat
- **39**: Matrize, plasmaätzresistent

- **40**: erste Passivierfläche hoher Oberflächenladung einer Polarität, z.B. positiv (gegenüber von 04)
- **42**: zweite Passivierfläche hoher Oberflächenladung entgegengesetzter Polarität, z.B. negativ (gegenüber von 05)
- **43**: elektrisch isolierender, dritter Passivierbereich ohne Oberflächenladung

- **d₁**: Schichtdicke von 30
- **d₂**: Schichtdicke von 32
- **E_{C}**: Energieniveau Leitungsband
- **E_{F}**: Fermi-Niveau
- **E_{V}**: Energieniveau Valenzband
- **L_{eff,min}**: effektive Diffusionslänge (minimal auftretend bei Minoritätsträger)
- **Lₓ**: Dicke von 03, 20
- **L_{y}**: mittlerer Abstand zwischen 11,12
- **W**: mittlere Weite von 06, 07

## Patentansprüche

1. Solarzelle (01) mit
• einer photoaktiven, halbleitenden Absorberschicht (03, 20), die der Erzeugung von Überschuss-Ladungsträger gegensätzlicher Polarität durch im Betriebsfall in die Vorderseite (13) der Absorberschicht (03, 20) einfallendes Licht dient,
• der Ausbildung zumindest eines elektrischen Feldes (08) in der Absorberschicht (03, 20), das der Trennung der photogenerierten Überschuss-Ladungsträger gegensätzlicher Polarität, die zumindest eine minimale effektive Diffusionslänge L_{eff, min} in der Absorberschicht (03, 20) zurücklegen können, dient,
• ersten Kontaktelementen (09), die der Ableitung der Überschuss-Ladungsträger einer Polarität auf der im Betriebsfall lichtabgewandten Rückseite (02) der Absorberschicht (03, 20) dienen,
• zweiten Kontaktelementen (10), die der Ableitung der Überschuss-Ladungsträger gegensätzlicher Polarität dienen, und
• zumindest einem auf die Rückseite (02) der Absorberschicht (03, 20) aufgebrachten nicht dotierten, elektrisch isolierenden ersten Passivierbereich (04) aus einem ersten nichthalbleitenden Material mit einer so hohen Oberflächenladung einer Polarität, dass eine Bandverbiegung der Absorberschicht (03, 20) in eine Richtung bis in oder nahe an deren Entartung hervorgerufen wird, und
• zumindest einem nicht dotierten, elektrisch isolierenden zweiten Passivierbereich (05) aus einem zweiten nichthalbleitenden Material mit einer so hohen Oberflächenladung gegensätzlicher Polarität, dass eine Bandverbiegung der Absorberschicht (03, 20) in die entgegengesetzte Richtung bis in oder nahe an die Entartung hervorgerufen wird,
• eine Anordnung auch der zweiten Kontaktelemente (10) auf der Rückseite (02) der Absorberschicht (03, 20),
• zumindest eine erste Kontaktöffnung (11) in jedem ersten elektrisch isolierenden Passivierbereich (04) zum Anschluss eines ersten Kontaktelements (09);
**GEKENNZEICHNET DURCH**
• eine alternierende benachbarte Anordnung mehrerer erster und zweiter elektrisch isolierender Passivierbereiche (04, 05) auf der Rückseite (02) der Absorberschicht (03, 20) mit einer Dicke Lₓ von 0 < Lₓ 5 L_{eff,min},
• zumindest eine zweite Kontaktöffnung (12) in jedem zweiten elektrisch isolierenden Passivierbereich (05) zum Anschluss eines zweiten Kontaktelements (10) und
• einen Abstand L_{y} zwischen jedem ersten und jedem zweiten Kontaktelement (09, 10) von 0< L_{y} ≤ 2 L_{eff}, ₘᵢₙ.

2. Solarzelle (01) nach Anspruch 1,
**GEKENNZEICHNET DURCH**
eine punkt- oder streifenförmige Ausbildung der ersten und zweiten Kontaktelemente (09, 10), insbesondere bestehend aus zwei Metallen mit entsprechend der Polarität der abzuführenden Überschuss-Ladungsträger unterschiedlicher Austrittsarbeit.

3. Solarzelle (01) nach Anspruch 1,
**GEKENNZEICHNET DURCH**
eine Anordnung der Kontaktöffnungen (11, 12) zumindest im Bereich der Flächenschwerpunkte der ersten und zweiten Passivierbereiche (04, 05).

4. Solarzelle (01) nach Anspruch 1,
**GEKENNZEICHNET DURCH**
eine Anordnung einer Vielzahl von stochastisch verteilten Kontaktöffnungen (11, 12) mit Nanoabmessungen in den ersten und zweiten Passivierbereichen (04, 05).

5. Solarzelle (01) nach Anspruch 1,
**GEKENNZEICHNET DURCH**
eine flächige Passivierschicht (14) auf der Vorderseite (13) der Absorberschicht (03, 20), insbesondere bestehend aus alternierenden elektrisch isolierenden ersten und zweiten Passivierflächen (40, 42) hoher Oberflächenladung mit gegensätzlicher Polarität mit gegensätzlicher Anordnung zu den ersten und zweiten Passivierbereichen (04, 05).

6. Solarzelle (01) nach Anspruch 1,
**GEKENNZEICHNET DURCH**
eine flächige oder strukturierte, elektrisch leitende intrinsische Passivierschicht (15) auf den ersten und/oder zweiten Passivierbereichen (04, 05), die die Absorberschicht (03, 20) im Bereich der Kontaktöffnungen (12) der ersten und/oder zweiten Passivierbereiche (04, 05) kontaktiert, wobei das Material für die elektrisch leitende intrinsische Passivierschicht (15) vorzugsweise intrinsisches a-Si:H ist.

7. Solarzelle (01) nach Anspruch 1,
**GEKENNZEICHNET DURCH**
einen schmalen, dünnen elektrisch isolierenden dritten Passivierbereich (43) ohne hohe Oberflächenladung zwischen den ersten und zweiten Passivierbereichen (04, 05),

8. Solarzelle (01) nach Anspruch 1,
**GEKENNZEICHNET DURCH**
eine dotierte Absorberschicht (20) und zusätzliche, gegensätzlich dotierte, heterogen aufgebrachte oder diffundierte Emitterschichten (22, 24, 25, 29) zumindest in den Kontaktöffnungen (11, 12) der ersten oder zweiten Passivierbereiche (04, 05) mit zur Absorberdotierung gleicher Oberflächenladung.

9. Solarzelle nach Anspruch 1,
**GEKENNZEICHNET DURCH**
eine dotierte Absorberschicht (20) und zusätzliche, gleich dotierte, heterogen aufgebrachte oder lokal oder flächig diffundierte BSF-Schichten (21, 23) zumindest in den Kontaktöffnungen (11, 12) der ersten oder zweiten Passivierbereiche (04, 05) mit zur Absorberdotierung gegensätzlicher Oberflächenladung.

10. Solarzelle nach Anspruch 8 und/oder 9,
**GEKENNZEICHNET DURCH**
eine Erstreckung der Emitterschichten (22, 24, 25, 29) und/oder BSF-Schichten (21,23) von den Kontaktöffnungen (11,12) her auf den ersten und/oder zweiten Passivierbereichen (04, 05) ohne eine gegenseitige Berührung.

11. Solarzelle (01) nach Anspruch 6,
**GEKENNZEICHNET DURCH**
eine dotierte Absorberschicht (20) und zusätzliche, gegensätzlich dotierte, heterogen aufgebrachte oder diffundierte Emitterschichten (22, 24, 25, 29) auf der flächigen oder strukturierten, elektrisch leitenden intrinsischen Passivierschicht (15).

12. Solarzelle nach Anspruch 6,
**GEKENNZEICHNET DURCH**
eine dotierte Absorberschicht (20) und zusätzliche, gleich dotierte, heterogen aufgebrachte oder lokal oder flächig diffundierte BSF-Schichten (21, 23) auf der flächigen oder strukturierten, elektrisch leitenden intrinsischen Passivierschicht (15).

13. Solarzelle nach Anspruch 1,
**GEKENNZEICHNET DURCH**
eine Absorberschicht (03, 30), eine Durchführung (27) der Kontaktöffnungen (12) in den ersten oder zweiten Passivierbereichen (04, 05) bis auf die Vorderseite (13) der Absorberschicht (20) und eine Belegung der durchgeführten Kontaktöffnungen (27, 12) und der Vorderseite (13) der Absorberschicht (20) mit dem Material der ersten oder zweiten Passivierbereiche (04, 05).

14. Solarzelle nach Anspruch 1,
**GEKENNZEICHNET DURCH**
intrinsisches oder dotiertes Silizium als Material für die Absorberschicht (03, 20), Siliziumnitrid (SiN) mit einer hohen positiven Oberflächenladung und Aluminiumoxid (AIO) mit einer hohen negativen Oberflächenladung als Materialien für die elektrisch isolierenden ersten und zweiten Passivierbereiche (04, 05) und ein Metall (Aluminium (Al)) oder ein transparent leitfähiges Oxid (TCO) (Zinkoxid (ZnO) oder Indiumzinnoxid (ITO)) als Material für die ersten und zweiten Kontaktelemente (09, 10).

15. Herstellungsverfahren für eine Solarzelle (01) nach einem der Ansprüche 1 bis 14 mit einer Anordnung einer Vielzahl von stochastisch verteilten Kontakt-öffnungen (11, 12) in den ersten und zweiten Passivierbereichen (04, 05), **GEKENNZEICHNET DURCH**
folgende Verfahrensschritte:
• rückseitige Deposition einer elektrisch isolierenden Passivierschicht (30) mit einer hohen Oberflächenladung einer Polarität mit einer Schichtdicke d₁ direkt auf die Absorberschicht (03) und Strukturierung der elektrisch isolierenden Passivierschicht (30) in die elektrisch isolierenden zweiten Passivierbereiche einer Polarität (05),
• rückseitige Deposition einer elektrisch isolierenden Passivierschicht (32) mit einer hohen Oberflächenladung gegensätzlicher Polarität mit einer Schichtdicke d₂ direkt auf die Absorberschicht (03) und direkt auf die zweiten Passivierbereiche (05) und Strukturierung elektrisch isolierenden Passivierschicht (32) in die elektrisch isolierenden ersten Passivierbereiche (04),
• ganzflächige Deposition einer Matrize (39) aus einem plasma-ätzresistenten Material, insbesondere aus ZnO, und anschließende Strukturierung der Matrize (39),
• partielles Abätzen der Matrize (39), bis diese an stochastisch verteilten Stellen vollständig abgetragen ist und
• selektives Ätzen in einem Plasma, das die ersten und zweiten Passivierbereiche (04, 05), nicht aber die Matrize (39) angreift, wobei die Schichtdicken d₁, d₂ der ersten und zweiten Passivierbereiche (04, 05) in Abhängigkeit von ihren Ätzraten so gewählt wurden, dass in beiden Passivierbereichen (04, 05) Kontaktöffnungen (11, 12) bis auf die Absorberschicht (03) entstehen.

## Claims

1. A solar cell (01) comprising:
• a photoactive, semiconductive absorber layer (03, 20) configured to generate excess charge carriers of opposing polarity by light incident on the front (13) of the absorber layer (03, 20) during operation,
• creation of at least one electric field (08) in the absorber layer (03, 20), configured to separate the photogenerated excess charge carriers of opposite polarity, which can shift by at least a minimum effective diffusion length L_{eff,min} in the absorber layer,
• first contact elements (09) configured on the rear side (02) of the absorber layer (03, 20) facing away from the light incident to dissipate the excess charge carriers having one polarity during operation,
• second contact elements (10) configured to dissipate the excess charge carriers having the opposite polarity, and
• at least a first undoped, electrically insulating passivation region (04) disposed on the rear side (02) of the absorber layer (03, 20) and consisting of a first non-semiconductive material with a surface charge of one polarity of such magnitude that band bending of the absorber layer (03, 20) occurs in one direction to the point or close to the point of degeneration thereof, and
• at least a second undoped, electrically insulating passivation region (05) consisting of a second non-semiconductive material with a surface charge of the opposite polarity of such magnitude that band bending of the absorber layer (03, 20) occurs in the opposite direction to the point or close to the point of degeneration thereof,
• an arrangement of the second contact elements (10) as well on the rear side (02) of the absorber layer (03, 20),
• at least one first contact opening (11) in each first electrically insulating passivation region (04) for connecting a first contact element (09)
**characterized by**
• an alternating neighbouring arrangement of multiple first and second electrically insulating passivation regions (04, 05) on the rear (02) of the absorber layer (03, 20) having a thickness Lₓ of 0 < Lₓ ≤ L_{eff,min},
• at least one second contact opening (12) in each second electrically insulating passivation region (05) for connecting a second contact element (10), and
• a distance L_{y} of 0 < L_{y} ≤ 2 L_{eff,min}, between each first and second contact element.

2. The solar cell (01) according to claim 1,
**characterized by**
a point-like and a strip-like configuration of the first and second contact elements (09, 10), consisting particularly of two metals with differing work functions corresponding to the polarity of the excess charge carriers to be dissipated.

3. The solar cell (01) according to claim 1,
**characterized by**
an arrangement of the contact openings (11, 12) at least close to the area centroids of the first and second passivation regions (04, 05).

4. The solar cell (01) according to claim 1,
**characterized by**
an arrangement of a plurality of contact openings (11, 12) in stochastic distribution and having nanodimensions in the first and second passivation regions (04, 05).

5. The solar cell (01) according to claim 1,
**characterized by**
planar passivation layer (14) disposed on the front (13) of the absorber layer (03, 20), particularly consisting of alternating electrically insulating first and second passivation surfaces (40, 42) having a high surface charge and opposite polarity with an opposite arrangement to the first and second passivation regions (04, 05).

6. The solar cell (01) according to claim 1,
**characterized by**
a planar or structured, electrically conductive intrinsic passivation layer (15) on the first and/or second passivation regions (05, 06), and which contacts the absorber layer (03, 20) in the area of the contact openings (12) of the first and/or second passivation regions (05, 06), wherein the material for the electrically conductive intrinsic passivation layer (15) is preferably intrinsic a-Si:H.

7. The solar cell (01) according to claim 1,
**characterized by**
a narrow, thin, electrically conductive third passivation region (43) with a high surface charge between the first and second passivation regions (04, 05).

8. The solar cell (01) according to claim 1,
**characterized by**
a doped absorber layer (20) and additional, contrastingly doped emitter layers (22, 24, 25, 29) that are applied heterogeneously or diffused, at least in the contact openings (11, 12) of the first or second passivation regions (04, 05) with the same surface charge for doping the absorber.

9. The solar cell according to claim 1,
**characterized by**
a doped absorber layer (20) and additional, identically doped BSF layers (21, 23) that are applied heterogeneously or diffused locally or over an area, at least in the contact openings (11, 12) of the first or second passivation regions (04, 05) with opposite surface charge for doping the absorber.

10. The solar cell according to claim 8 and/or 9,
**characterized by**
an extension of the emitter layers (22, 24, 25, 29) and/or the BSF layers (21, 23) from the contact openings (11, 12) as far as the first and/or second passivation regions (04, 05) without mutual contact.

11. The solar cell (01) according to claim 6,
**characterized by**
a doped absorber layer (20) and additional, oppositely doped emitter layers (22, 24, 25, 29) that are applied heterogeneously or diffused onto the flat or structured, electrically conductive intrinsic passivation layer (15).

12. The solar cell according to claim 6,
**characterized by**
a doped absorber layer (20) and additional, identically doped BSF layers (21, 23) that are applied heterogeneously or diffused locally or over an area onto the flat or structured, electrically conductive intrinsic passivation layer (15).

13. The solar cell according to claim 1,
**characterized by**
an absorber layer (03, 30), a passthrough (27) of the contact openings (12) in the first or second passivation regions as far as the front (13) of the absorber layer (20) and an occupancy of the penetrating contact openings (27, 12) and of the front (13) of the absorber layer (20) by the material of the first or second passivation regions (04, 05).

14. The solar cell according to claim 1,
**characterized by**
intrinsic or doped silicon as the material of the absorber layer (03, 20), silicon nitride (SiN) with a strong positive surface charge and aluminium oxide (AIO) with a strong negative surface charge as materials for the electrically insulating first and second passivation regions (04, 05), and a metal (aluminium Al) or a transparently conductive oxide (TCO) (zinc oxide ZnO) or indium tin oxide (ITO) as the material for the first and second contact elements (09, 10).

15. A production process for a solar cell (01) according to any of claims 1 to 14, comprising an arrangement of a plurality of contact openings (11, 12) in stochastic distribution in the first and second passivation regions (04, 05),
**characterized by**
the following process steps:
• depositing on the rear an electrically insulating passivation layer (30) having a strong surface charge of one polarity with a layer thickness d₁ directly on the absorber layer (03) and structuring the electrically insulating passivation layer (30) into the electrically insulating passivation regions of one polarity (05),
• depositing on the rear an electrically insulating passivation layer (32) having a strong surface charge of the opposite polarity with a layer thickness d₂ directly on the absorber layer (03) and directly on the second passivation regions (05) and structuring the electrically insulating passivation layer (32) into the electrically insulating first passivation regions (04),
• depositing over the entire area a matrix (39) consisting of a material that is resistant to plasma etching, particularly ZnO, and subsequent structuring of the matrix (39);
• removal of part of the matrix (39) by etching, until the matrix is completely removed at stochastically distributed points, and
• selective etching in a plasma that erodes the first and second passivation regions (04, 05) but not the matrix (39), wherein the layer thicknesses d₁, d₂ of the first and second passivation regions (04, 05) are selected according to their etching rates such that contact openings (11, 12) are created as far as the absorber layer (03) in both passivation regions (04, 05).

## Revendications

1. Cellule solaire (01) avec
• une couche d'absorbeur (03, 20) photo-active semi-conductrice, laquelle sert à la génération de porteurs de charge excédentaires à polarité opposée grâce à de la lumière incidente sur la face avant (13) de la couche d'absorbeur (03, 20) en cas de fonctionnement,
• la formation d'au moins un champ électrique (08) dans la couche d'absorbeur (03, 20), lequel sert à la séparation des porteurs de charge excédentaires photo-générés à polarité opposée, lesquels peuvent parcourir au moins une longueur de diffusion L_{elf,min} effective minimale dans la couche d'absorbeur (03, 20),
• des premiers éléments de contact (09), lesquels servent à la dérivation des porteurs de charge excédentaires d'une polarité sur la face arrière (02) de la couche d'absorbeur (03, 20) tournant le dos à la lumière en cas de fonctionnement,
• des deuxièmes éléments de contact (10), lesquels servent à la dérivation des porteurs de charge excédentaires à polarité opposée, et
• au moins une première zone de passivation (04) non dopée, d'isolation électrique, appliquée sur la face arrière (02) de la couche d'absorbeur (03, 20) et en un premier matériau non semiconducteur avec une charge superficielle si élevée d'une polarité, qu'une torsion de bande de la couche d'absorbeur (03, 20) dans une direction jusqu'à la dénaturation de celle-ci ou la quasi dénaturation de celle-ci est provoquée, et
• au moins une deuxième zone de passivation (05) non dopée d'isolation électrique en un deuxième matériau non semiconducteur avec une charge superficielle si élevée d'une polarité opposée, qu'une torsion de bande de la couche d'absorbeur (03, 20) dans la direction opposée est provoquée jusqu'à la dénaturation de celle-ci ou la quasi dénaturation de celle-ci,
• un agencement également de deuxièmes éléments de contact (10) sur la face arrière (02) de la couche d'absorbeur (03, 20),
• au moins une première ouverture de contact (11) dans chaque première zone de passivation (04) d'isolation électrique pour le raccordement d'un premier élément de contact (09) ;
**caractérisée par**
• un agencement voisin en alternance de plusieurs premières et deuxièmes zones de passivation (04, 05) isolées électriquement sur la face arrière (02) de la couche d'absorbeur (03, 20) avec une épaisseur de Lₓ de 0 < Lₓ ≤ L_{eff,min},
• au moins une deuxième ouverture de contact (12) dans chaque deuxième couche de passivation (05) d'isolation électrique pour le raccordement d'un deuxième élément de contact (10), et
• un espacement L_{y} entre chaque premier et chaque deuxième élément de contact (09, 10) de 0 < L_{y} ≤ 2 L_{eff,min}.

2. Cellule solaire (01) selon la revendication 1,
**caractérisée par**
une formation en forme de point ou de bande des premiers et deuxièmes éléments de contact (09, 10), se composant en particulier de deux métaux avec un travail d'extraction qui diffère en fonction de la polarité des porteurs de charge excédentaires à évacuer.

3. Cellule solaire (01) selon la revendication 1,
**caractérisée par**
un agencement des ouvertures de contact (11, 12), au moins dans la zone de centre de gravité de surface, des premières et deuxièmes zones de passivation (04, 05).

4. Cellule solaire (01) selon la revendication 1,
**caractérisée par**
un agencement d'une pluralité d'ouvertures de contact (11, 12) réparties stochastiquement avec des nano-dimensions dans les premières et deuxièmes zones de passivation (04, 05).

5. Cellule solaire (01) selon la revendication 1,
**caractérisée par**
une couche de passivation plane (14) sur la face avant (13) de la couche d'absorbeur (03, 20), se composant en particulier de premières et deuxièmes surfaces de passivation (40, 42) d'isolation électrique en alternance à charge superficielle élevée d'une polarité opposée avec un agencement antagoniste par rapport aux premières et deuxièmes zones de passivation (04, 05).

6. Cellule solaire (01) selon la revendication 1,
**caractérisée par**
une couche de passivation intrinsèque électro-conductrice plane ou structurée (15) sur les premières et/ou deuxièmes zones de passivation (04, 05), laquelle entre en contact avec la couche d'absorbeur (03, 20) dans la zone des ouvertures de contact (12) des premières et/ou deuxièmes zones de passivation (04, 05), le matériau pour la couche de passivation intrinsèque électro-conductrice (15) étant de préférence du a-Si:H intrinsèque.

7. Cellule solaire (01) selon la revendication 1,
**caractérisée par**
une troisième zone de passivation (43) d'isolation électrique fine et étroite sans charge superficielle élevée entre les premières et deuxièmes zones de passivation (04, 05).

8. Cellule solaire (01) selon la revendication 1,
**caractérisée par**
une couche d'absorbeur (20) dopée et des couches d'émission (22, 24, 25, 29) supplémentaires dopées de manière opposée, appliquées de façon hétérogène ou diffusées au moins dans les ouvertures de contact (11, 12) des premières ou deuxièmes zones de passivation (04, 05) avec une charge superficielle identique à celle du dopage d'absorbeur.

9. Cellule solaire selon la revendication 1,
**caractérisée par**
une couche d'absorbeur dopée (20) des couches BSF (21, 23) supplémentaires dopées de manière identique, appliquées de façon hétérogène ou diffusées localement ou de façon plane au moins dans les ouvertures de contact (11, 12) des premières ou deuxièmes zones de passivation (04, 05) avec une charge superficielle opposée par rapport au dopage d'absorbeur.

10. Cellule solaire selon les revendications 8 et/ou 9,
**caractérisée par**
une extension des couches d'émission (22, 24, 25, 29) et ou couches BSF (21, 23) à partir des ouvertures de contact (11, 12) sur les premières et/ou deuxièmes zones de passivation (04, 05) sans contact réciproque.

11. Cellule solaire (01) selon la revendication 6,
**caractérisée par**
une couche d'absorbeur dopée (20) et des couches d'émission (22, 24, 25, 29) supplémentaires dopées de manière opposée, appliquées de façon hétérogène ou diffusées sur la couche de passivation (15) intrinsèque électro-conductrice plane ou structurée.

12. Cellule solaire selon la revendication 6,
**caractérisée par**
une couche d'absorbeur dopée (20) et des couches BSF (21, 23) supplémentaires dopées de manière identique, appliquées de façon hétérogène ou diffusées localement ou de façon plane sur la couche de passivation (15) intrinsèque électro-conductrice plane ou structurée.

13. Cellule solaire selon la revendication 1,
**caractérisée par**
une couche d'absorbeur (03, 30), une traversée (27) des ouvertures de contact (12) dans les premières ou deuxièmes zones de passivation (04, 05) jusqu'à la face avant (13) de la couche d'absorbeur (20) et une occupation des ouvertures de contact (27, 12) traversées et de la face avant (13) de la couche d'absorbeur (20) par le matériau des premières ou deuxièmes zones de passivation (04, 05).

14. Cellule solaire selon la revendication 1,
**caractérisée par**
du silicium intrinsèque ou dopé en tant que matériau pour la couche d'absorbeur (03, 20), du nitrure de silicium (SiN) avec une charge superficielle positive élevée et de l'oxyde d'aluminium (AlO) avec une charge superficielle négative élevée en tant que matériaux pour les premières et deuxièmes zones de passivation d'isolation électrique (04, 05) et un métal (aluminium (Al)) ou un oxyde à capacité conductrice transparent (TCO) (oxyde de zinc (ZnO) ou oxyde d'indium et d'étain (ITO)) en tant que matériau pour les premiers et deuxièmes éléments de contact (09, 10).

15. Procédé de fabrication pour une cellule solaire (01) selon l'une des revendications 1 à 14 avec un agencement d'une pluralité d'ouvertures de contact (11, 12) réparties stochastiquement dans les premières et deuxièmes zones de passivation (04, 05),
**caractérisé par**
les étapes suivantes du procédé :
• dépôt sur face arrière d'une couche de passivation d'isolation électrique (30) avec une charge superficielle élevée d'une polarité, avec une épaisseur de couche d₁, directement sur la couche d'absorbeur (03) et structuration de la couche de passivation d'isolation électrique (30) dans les deuxièmes zones de passivation d'isolation électrique d'une polarité (05),
• dépôt sur face arrière d'une couche de passivation d'isolation électrique (32) avec une charge superficielle élevée à polarité opposée, avec une épaisseur de couche d₂, directement sur la couche d'absorbeur (03) et directement sur les deuxièmes zones de passivation (05) et structuration d'une couche de passivation d'isolation électrique (32) dans les premières zones de passivation (04) d'isolation électrique,
• dépôt sur toute la surface d'une matrice (39) en un matériau résistant à la gravure par plasma, en particulier en ZnO, et ensuite structuration de la matrice (39),
• gravure partielle de la matrice (39) jusqu'à ce que celle-ci soit entièrement érodée au niveau d'emplacements répartis stochastiquement et
• gravure sélective dans un plasma qui attaque les premières et deuxièmes zones de passivation (04, 05) mais non pas la matrice (39), les épaisseurs de couche d₁, d₂ des premières et deuxièmes zones de passivation (04, 05) ayant été choisies en fonction de leurs taux de gravure de manière à ce que des ouvertures de contact (11, 12) jusqu'à la couche d'absorbeur (03) soient formées dans les deux zones de passivation (04, 05).
